(19) Europäisches Patentamt
European Patent Office
Office européen des brevets

(11) **EP 4 181 654 A1**

(12) # EUROPEAN PATENT APPLICATION

(43) Date of publication:
**17.05.2023 Bulletin 2023/20**

(21) Application number: **22207241.5**

(22) Date of filing: **14.11.2022**

(51) International Patent Classification (IPC):
**H10K 59/80** (2023.01)   **H10K 50/86** (2023.01)
**H10K 50/858** (2023.01)   **H10K 50/828** (2023.01)

(52) Cooperative Patent Classification (CPC):
**H10K 59/8791; H10K 50/828; H10K 50/858;
H10K 50/86**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **12.11.2021 US 202163278640 P
02.11.2022 US 202217979278**

(71) Applicant: **Universal Display Corporation
Ewing, NJ 08618 (US)**

(72) Inventors:
• **MUNDOOR, Haridas
Ewing, New Jersey, 08618 (US)**
• **THOMPSON, Nicholas J.
Ewing, New Jersey, 08618 (US)**
• **MENON, Vinod M.
Ewing, New Jersey, 08618 (US)**

(74) Representative: **Maiwald GmbH
Engineering
Elisenhof
Elisenstrasse 3
80335 München (DE)**

(54) **ORGANIC ELECTROLUMINESCENT DEVICES**

(57)   High-efficiency plasmonic OLED displays are provided that use the design of the plasmonic device to overcome some of the shortcomings of conventional display panels. Control of the Stokes parameters of the emitted light and/or modification of the ambient light incident on the device relative to the emitted light is used to maximize the amount of visible light emitted by the display.

# FIG. 5B

**Description**

CROSS-REFERENCE TO RELATED APPLICATIONS

This application claims the benefit of U.S. Patent Application Serial No. 63/278,640, filed November 12, 2022, the entire contents of which are incorporated herein by reference.

FIELD

The present invention relates to devices and techniques for fabricating organic emissive devices that include an enhancement layer and an outcoupling layer arranged to achieve a desired polarization or other optical effect, such as organic light emitting diodes, and devices and techniques including the same.

BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745, which are incorporated herein by reference in their entirety.

One application for phosphorescent emissive molecules is a full color display. Industry standards for such a display call for pixels adapted to emit particular colors, referred to as "saturated" colors. In particular, these standards call for saturated red, green, and blue pixels. Alternatively the OLED can be designed to emit white light. In conventional liquid crystal displays emission from a white backlight is filtered using absorption filters to produce red, green and blue emission. The same technique can also be used with OLEDs. The white OLED can be either a single EML device or a stack structure. Color may be measured using CIE coordinates, which are well known to the art.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

Layers, materials, regions, and devices may be described herein in reference to the color of light they emit. In general, as used herein, an emissive region that is described as producing a specific color of light may include one or more emissive layers disposed over each other in a stack.

As used herein, a "red" layer, material, region, or device refers to one that emits light in the range of about 580-700nm or having a highest peak in its emission spectrum in that region. Similarly, a "green" layer, material, region, or device refers to one that emits or has an emission spectrum with a peak wavelength in the range of about 500-600nm; a "blue" layer, material, or device refers to one that emits or has an emission spectrum with a peak wavelength in the range of about 400-500nm; and a "yellow" layer, material, region, or device refers to one that has an emission spectrum with a peak wavelength in the range of about 540-600nm. In some arrangements, separate regions, layers, materials, regions, or devices may provide separate "deep blue" and a "light blue" light. As used herein, in arrangements that provide separate "light blue" and "deep blue", the "deep blue" component refers to one having a peak emission wavelength that is at least about 4nm less than the peak emission wavelength of the "light blue" component. Typically, a "light blue" component has a peak emission wavelength in the range of about 465-500nm, and a "deep blue" component has a peak emission wavelength in the range of about 400-470nm, though these ranges may vary for some configurations. Similarly, a color altering layer refers to a layer that converts or modifies another color of light to light having a wavelength as specified for that color. For example, a "red" color filter refers to a filter that results in light having a wavelength in the range of about 580-700nm. In general, there are two classes of color altering layers: color filters that modify a spectrum by removing unwanted wavelengths of light, and color changing layers that convert photons of higher energy to lower energy. A component "of a color" refers to a component that, when activated or used, produces or otherwise emits light having a particular color as previously described. For example, a "first emissive region of a first color" and a "second emissive region of a second color different than the first color" describes two emissive regions that, when activated within a device, emit two different colors as previously described.

As used herein, emissive materials, layers, and regions may be distinguished from one another and from other structures based upon light initially generated by the material, layer or region, as opposed to light eventually emitted by the same or a different structure. The initial light generation typically is the result of an energy level change resulting in emission of a photon. For example, an organic emissive material may initially generate blue light, which may be converted by a color filter, quantum dot or other structure to red or green light, such that a complete emissive stack or sub-pixel emits the red or green light. In this case the initial emissive material or layer may be referred to as a "blue" component, even though the sub-pixel is a "red" or "green" component.

In some cases, it may be preferable to describe the color of a component such as an emissive region, sub-pixel, color altering layer, or the like, in terms of 1931 CIE coordinates. For example, a yellow emissive material may have multiple peak emission wavelengths, one in or near an edge of the "green" region, and one within or near an edge of the "red" region as previously described. Accordingly, as used herein, each color term also corresponds to a shape in the 1931 CIE coordinate color space. The shape in 1931 CIE color space is constructed by following the locus between two color points and any additional interior points. For example, interior shape parameters for red, green, blue, and yellow may be defined as shown below:

| Color | CIE Shape Parameters |
|---|---|
| Central Red | Locus: [0.6270,0.3725];[0.7347,0.2653]; Interior:[0.5086,0.2657] |
| Central Green | Locus: [0.0326,0.3530];[0.3731,0.6245]; Interior: [0.2268,0.3321] |
| Central Blue | Locus: [0.1746,0.0052];[0.0326,0.3530]; Interior: [0.2268,0.3321] |

(continued)

| Color | CIE Shape Parameters |
|---|---|
| Central Yellow | Locus: [0.373 l,0.6245];[0.6270,0.3725]; Interior: [0.3 700,0.4087];[0.2886,0.4572] |

More details on OLEDs, and the definitions described above, can be found in US Pat. No. 7,279,704, which is incorporated herein by reference in its entirety.

SUMMARY

According to an embodiment, an organic light emitting diode/device (OLED) is also provided. The OLED can include an anode, a cathode, and an organic layer, disposed between the anode and the cathode. According to an embodiment, the organic light emitting device is incorporated into one or more device selected from a consumer product, an electronic component module, and/or a lighting panel.

In an embodiment, a device is provides that includes a substrate; a first electrode disposed over the substrate; an organic emissive material disposed over the first electrode; an enhancement layer comprising a plasmonic material that exhibits surface plasmon resonance disposed over the organic emissive material; and an outcoupling layer comprising metal nanostructures disposed over the enhancement layer that causes light emitted by the device to have circular polarization with a Stokes parameter S3 having an absolute value of 0.1 or greater. The enhancement layer may provide a second electrode for the device. The device may include a quarter-wave plate and/or linear polarizer disposed over the outcoupling layer. The enhancement layer may include silver, gold, aluminum, palladium, and/or platinum. Light emitted by the device may have a Stokes parameter $S_3$ such that $0.1 < |S_3| < 0.5$, $0.5 < |S_3| < 0.75$, or $0.75 < |S_3| < 1$. A layer of dielectric material may be disposed between the enhancement layer and the outcoupling layer. The thickness of the dielectric layer may be less than 150 nm, less than 10 nm, less than 20 nm, less than 30 nm, less than 50 nm, or less than 100 nm. It may have a refractive index of less than 2, less than 1.4, less than 1.6, or less than 1.8. The metal nanostructures may include silver, gold, aluminum, palladium, and/or platinum. The outcoupling layer may include a plurality of unit cells, each of which includes a pair of rectangular metal nanostructures having a major axis, wherein the pair of rectangular metal nanostructures is arranged such that the long axes are non-parallel and the edge-to-edge separation between the pair of rectangular nanostructures is shortest between closest ends of the pair. The major axes of each pair of rectangular metal nanostructures in each unit cell may be arranged at a relative angle of 75°-90°, 30°-60°, less than 30°, or 60° or more. The metal nanostructures may be rectangular. The metal nanostructures may have a non-uniform cross-section in a direction perpendicular to the substrate and/or a non-uniform composition in a direction perpendicular to the substrate, which may include a dielectric material. In such arrangements, the relative proportion of the dielectric material may be non-uniform in the direction perpendicular to the substrate. The metal nanostructures may be arranged in a periodic lattice having different periodicities in orthogonal directions. The metal nanostructures may have a largest axis of less than 10 nm, less than 25 nm or less than 50 nm. The metal nanostructures may have one or more shapes, including spherical, cylindrical, star-shaped plates, hexagonal-shaped plates and random shaped structures. The out-coupling layer may include a dielectric material containing the metal nanostructures. The dielectric material containing the metal nanostructures may have a refractive index less than 1.4, less than 1.6, or less than 2. The outcoupling layer may have different effective indices of refraction along two orthogonal directions. The metal nanostructures may have in-plane dimensions of 50-500 nm, at least 100 nm, at least 150 nm, or at least 250 nm. The metal nanostructures may have out-of-plane dimensions of 30-500 nm, at least 100 nm, at least 150 nm, or at least 250 nm. The metal nanostructures have various shapes including cylinders, rectangles, cubes, rods, spheres, and hemispheres. The edge-to-edge spacing of the metal nanostructures along one of the orthogonal directions in a lattice may be less than an average in-plane dimension of the metal nanostructures along the same direction. The device may include a dielectric material disposed under the metal nanostructures. A dielectric material may be disposed on at least some rows of the metal nanoparticle lattice when the nanostructures are arranged in a lattice. The lattice may include a plurality of rows of the metal nanostructures and metal nanostructures in a first of the plurality of rows have different composition and/or physical dimensions than metal nanoparticles in a second of the plurality of rows. The metal nanostructures may include elliptical bullseye nanostructures, which may have concentric grooves and rings that create a $\pi/2$ phase difference between orthogonal components of light outcoupled by the outcoupling layer. The metal nanostructures may include multiple chiral plasmonic nanostructures, a chiral nematic phase of colloidal metal nanostructures, and/or a chiral arrangement of rod-shaped metal nanostructures. The nanostructures may include rod-shaped nanostructures dispersed in a cellulose nanocrystal medium to generate circular polarized light emission. The outcoupling layer may exhibit circular dichroism. The nanoparticles may be dispersed in a chiral thermotropic liquid crystal. The device may be a display panel, in which case a quarter-wave plate, linear polarizer, and/or one or more color filter may be disposed over an entire active area of the display panel.

In an embodiment, a consumer electronic device comprising a display panel formed from such a device is provided. The consumer electronic device may be a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video walls comprising multiple displays tiled together, a theater or stadium screen, a sign, or a combination thereof.

In an embodiment, a device is provided that includes a substrate; a first electrode disposed over the substrate; an organic emissive material disposed over the first electrode; and an enhancement layer comprising plasmonic material that exhibits surface plasmon resonance; wherein the enhancement layer includes a plurality of holes and/or recessions or the device further includes a dielectric layer disposed over the enhancement layer, and an outcoupling layer comprising a metal layer comprising holes and/or recessions disposed over the dielectric layer. The device may include a quarter-wave plate and/or polarizer disposed over the enhancement layer; and/or a color filter disposed over the enhancement layer or outcoupling layer. The holes and/or recessions may have a variety of shapes, including elliptical, rectangular, circular, hexagonal, and irregular. Light emitted by the device may be circularly polarized with Stokes parameter $S_3$ having an absolute value greater than 0.1 and/or Stokes parameters $S_1$ and/or $S_2$ having an absolute value greater than 0.1. Light emitted by the device may have a Stokes parameter $S_3$ such that $0.1 < |S3| < 0.5$, $0.5 < |S_3| < 0.75$, or $0.75 < |S_3| < 1$. Light emitted by the device, may have Stokes parameters $S_1$ and $S_2$ such that $0.1 < |S_1| < 0.5$ and/or $0.1 < |S_2| < 0.5$, $0.5 < |S_1| < 0.75$ and/or $0.5 < |S_2| < 0.75$, or $0.75 < |S_1| < 1$ and/or $0.75 < |S_2| < 1$. The arrangements of holes and/or recessions may be random, in which case emission from the device may be unpolarized. The holes and/or recession may be arranged in a periodic lattice. The device may include an outcoupling layer and the refractive index of the dielectric layer may be less than 1.4, less than 1.5, less than 1.8 or less than 2. The device may include an outcoupling layer and the outcoupling layer may include materials such as silver, gold, aluminum, palladium, and/or platinum. The enhancement layer may include materials such as silver, gold, aluminum, palladium, and/or platinum.

In an embodiment, a device is provided that includes a substrate; a first electrode disposed over the substrate; an organic emissive material disposed between the first electrode and the second electrode; an enhancement layer comprising a plasmonic material that exhibits surface plasmon resonance; and an outcoupling layer comprising metal nanostructures that causes light emitted by the device to have linear polarization with Stokes parameters $S_1$ and/or $S_2$ having an absolute value of 0.1 or greater. Light emitted by the device may have Stokes parameters $S_1$, $S_2$ such that $0.1 < |S_1| < 0.5$ and/or $0.1 < |S_2| < 0.5$, $0.5 < |S_1| < 0.75$ and/or $0.5 < |S_2| < 0.75$, $0.75 < |S_1| < 1$ and/or $0.75 < |S_2| < 1$.

In an embodiment, a device is provided that includes a first electrode; a second electrode; an organic emissive material disposed between the first electrode and the second electrode; an enhancement layer comprising a plasmonic material that exhibits surface plasmon resonance, wherein the enhancement layer comprises the second electrode or the enhancement layer is a separate layer in the device; and an outcoupling layer comprising metal nanostructures. The device may include a quarter-wave plate and/or linear polarizer disposed over the outcoupling layer; and/or a color filter disposed over the outcoupling layer. The device may be a display panel, in which case the quarter-wave plate, linear polarizer, and/or the color filter may be disposed over an entire active area of the display panel. The device may include a layer of dielectric material disposed between the enhancement layer and the outcoupling layer. The arrangement of metal nanostructures may be random, in which case the emission from the device may be unpolarized. The metal nanostructures in the outcoupling layer may have at least one flat face. The metal nanostructures may have shapes such as rectangular, star shaped plates, hexagonal shaped plates, triangular bipyramids, triangular pyramid, square pyramid and random shaped structures. The layer of dielectric material may have a thickness of 5-30 nm, less than 30 nm, less than 20 nm, less than 10 nm, or less than 5 nm. The dielectric material may have a refractive index of less than 3, less than 2, less than 1.5, or less than 1.2. The metal nanostructures may couple to the enhancement layer to form an optical nanopatch antenna. The metal nanostructures may absorb ambient light by the excitation of cavity-like gap modes. An ambient light absorption wavelength region due to the metal nanostructures may be tuned to match with the EL emission wavelength. The metal nanostructures may have in-plane dimensions of 20-250 nm and/or out-of-plane dimensions of 20-250 nm. The overall ambient light reflection by the device in the 400-700 nm wavelength region may be less than 10%, less than 7%, or less than 5%. Ambient light absorption by the nanostructures may be limited to wavelength regions near an emission wavelength of the emissive layer. The device may include an absorptive band pass filter with transmission band matching an emission of the emissive layer. The device may include an absorptive filter that absorbs ultra violet (UV) light. The device may include an antireflecting coating. The device may include a color filter or down conversion layer arranged and configured to modify an emission spectrum of the outcoupling layer. The dielectric material may include fluorescence dyes and/or semiconducting quantum dots. The dielectric material may include one or more materials including Perylene, Boron di-pyrromethene, Rhodamine, Fluorescein, Fluorescein isothiocyanate, Calcein, Ethidiumbromide, Phycoerythrin, Carboxynaphthofluorescein, Hexachlorofluorescein, Tetramethylrhodamine, Phenylethynylpyrene, and quantum-confined nano crystals of cadmium selenide, cadmium sulfide, cadmium telluride, core shell cadmium selenide-zinc sulfide, core shell cadmium selenide-zinc selenide, lead sulfide, and zinc selenide. The dielectric materials may have a light absorption of less than 5%, less than 10 %, or less than 25%. Light absorption of the dielectric material may be enhanced by metal nanostructures in the outcoupling layer and/or the enhancement layer. The device may include an absorptive band pass filter with a transmission band matching emission of the emissive layer.

BRIEF DESCRIPTION OF THE DRAWINGS

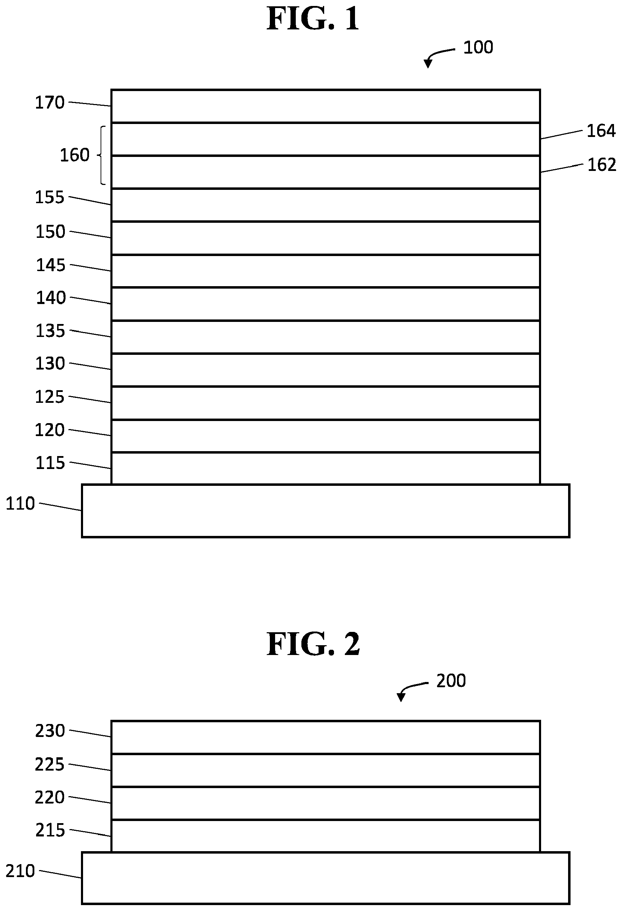

FIG. 1 shows an organic light emitting device.

FIG. 2 shows an inverted organic light emitting device that does not have a separate electron transport layer.

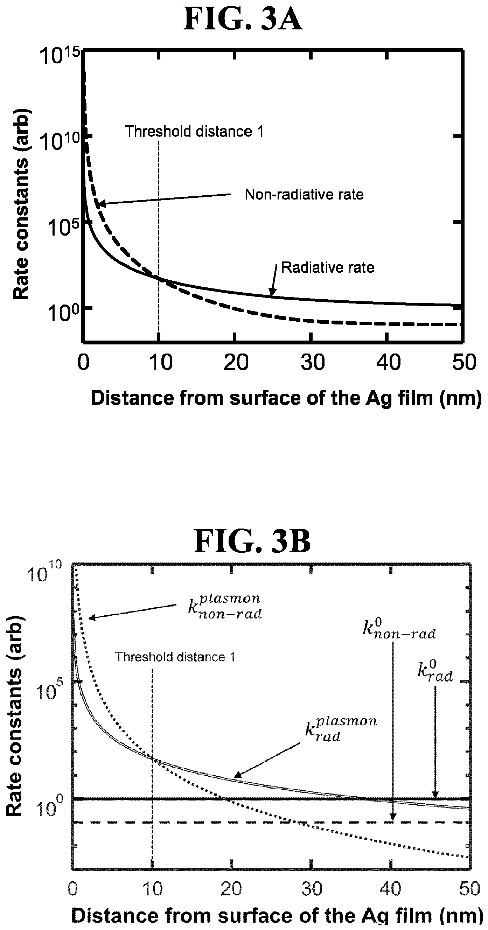

FIG. 3A shows a depiction of the rate constants versus distance from the surface of the silver film for an embodiment of an emissive material in an OLED with an enhancement layer of a silver film as disclosed herein. The distance is the distance from the metallic film surface closest to the emissive layer to the emissive material. A dashed line marks the distance at which the radiative rate is equal to the non-radiative rate and is threshold distance 1 as defined herein.

FIG. 3B shows rate constants versus distance from the surface of the silver film for an embodiment of an emissive material in an OLED with an enhancement layer of a silver film where the rate constants are broken out into example components as demonstrated in equation 3 as disclosed herein. The distance is the distance from the metallic film surface closest to the emissive layer to the emissive material.

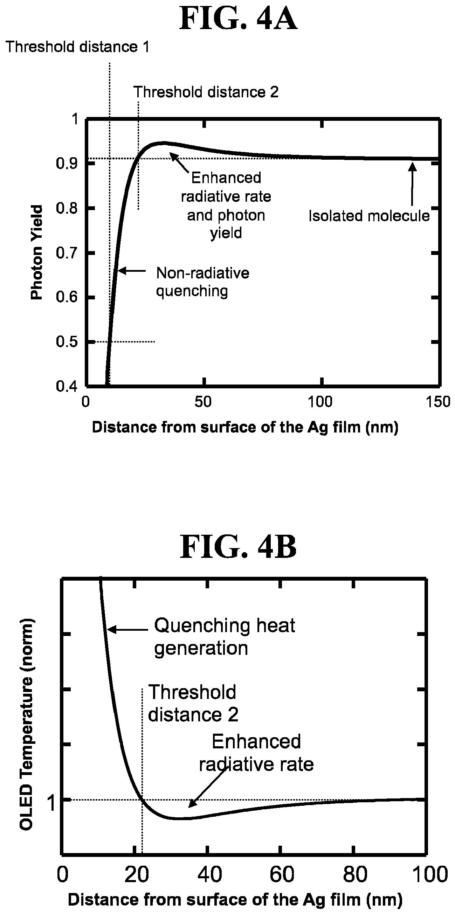

FIG. 4A shows photon yield versus distance from the surface of the silver film for an embodiment of an emissive material in an OLED with an enhancement layer of a silver film plotted for the rate constants in FIGS. 3A and 3B as disclosed herein. In this embodiment no outcoupling structure is part of or near the enhancement layer so all non-radiative coupling is dissipated as heat.

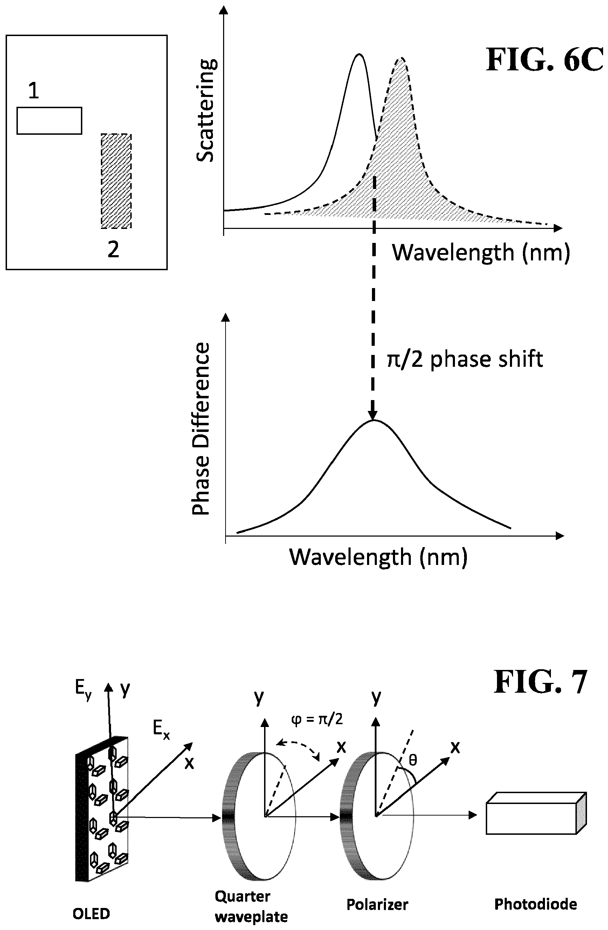

FIG. 4B shows the temperature of the OLED as a function of distance from the surface of the silver film for an embodiment of an emissive material in an OLED with an enhancement layer of a silver film plotted for the rate constants in FIGS. 7A and 7B as disclosed herein. In this embodiment no outcoupling structure is part of or near the enhancement layer so all non-radiative coupling is dissipated as heat which then increases the temperature of the OLED.

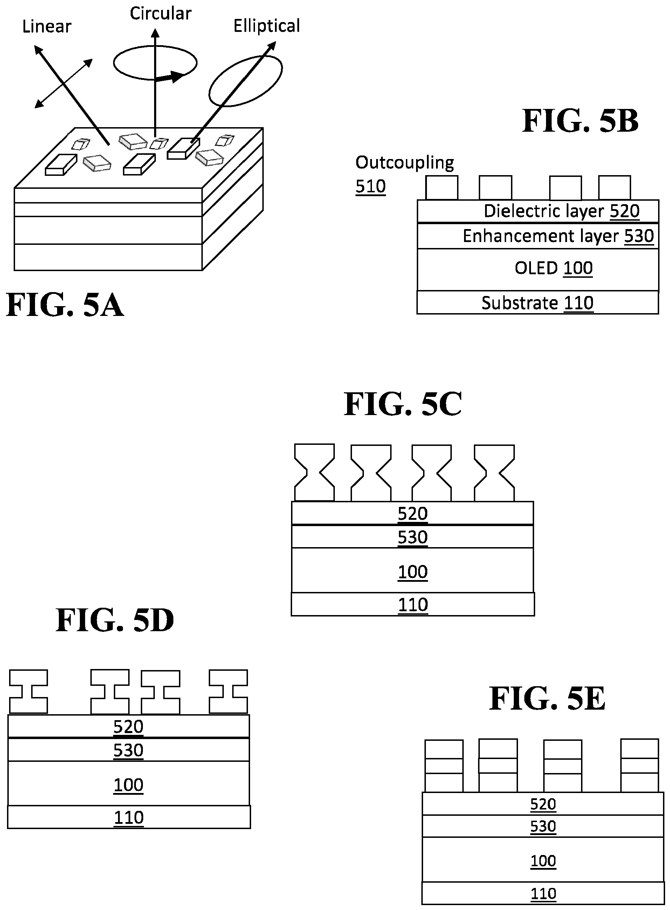

FIGS. 5A, 5B, 5C, 5D, and 5E show various views of a plasmonic OLED including an outcoupling layer with metal nanostructures as disclosed herein. FIG. 5A shows an example of polarization control of light emitted by such a device. FIG. 5B shows a side view of the general arrangement of the device. FIG. 5C and FIG. 5D show examples of devices having three dimensional metal nano structures with a thinner metal region at the middle. FIG. 5E shows an example of such a device in which the metal nanostructures have a metal-insulator-metal structure (MIM).

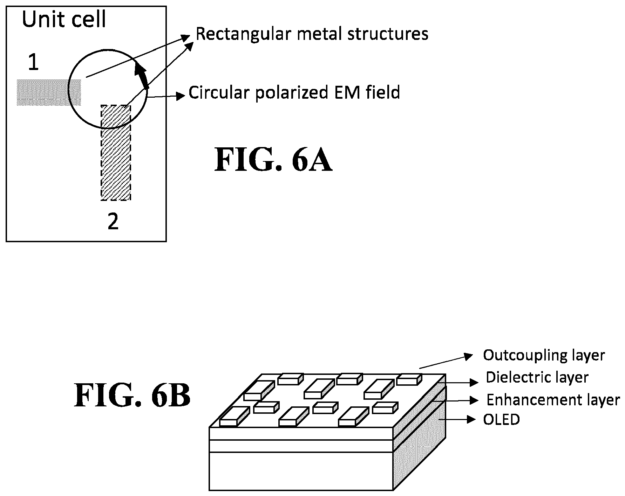

FIG. 6A and 6B show top and side schematic views of a device as disclosed herein in which the outcoupling layer provides circularly polarized emission using achiral metal nanostructures. FIG. 6C shows the principle of operation for generating circularly-polarized light from non-chiral nanostructures as disclosed herein.

FIG. 7 shows an example of an experimental setup indicating the orientation of polarizer and quarter waveplate used for measuring the Stoke's parameters of an OLED device as disclosed herein.

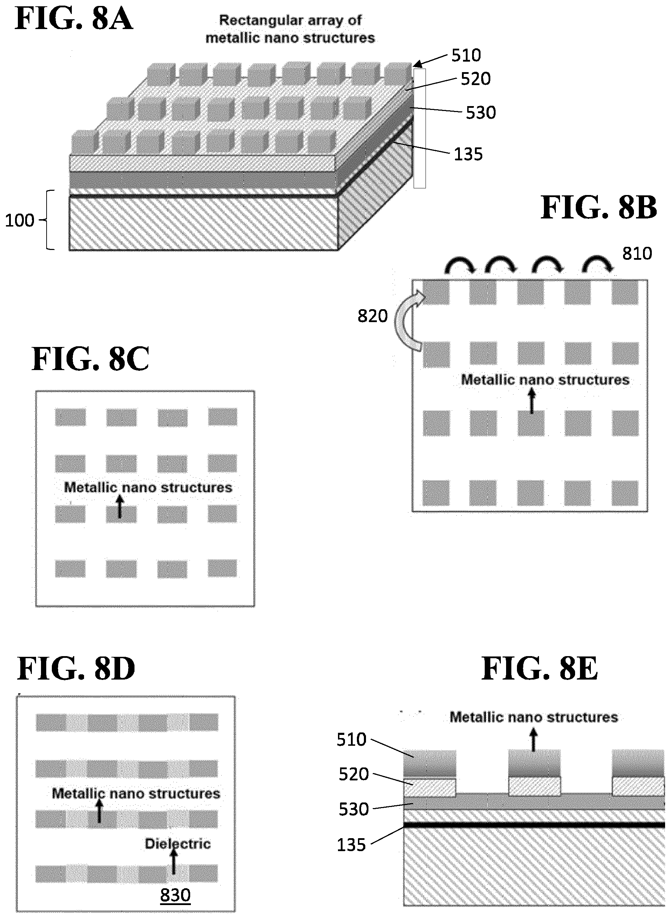

FIGS. 8A-8E show examples of rectangular array designs that allow for polarization control of the EL emission from plasmonic OLED structures. FIG. 8A shows a perspective view of an example device; FIG. 8B shows an example of a lattice having different periodicity in two orthogonal directions; FIG. 8C shows an example of non-uniform nanostructures in the lattice; FIGS. 8D and 8E show arrangements that include a dielectric material between and/or under the nanostructures.

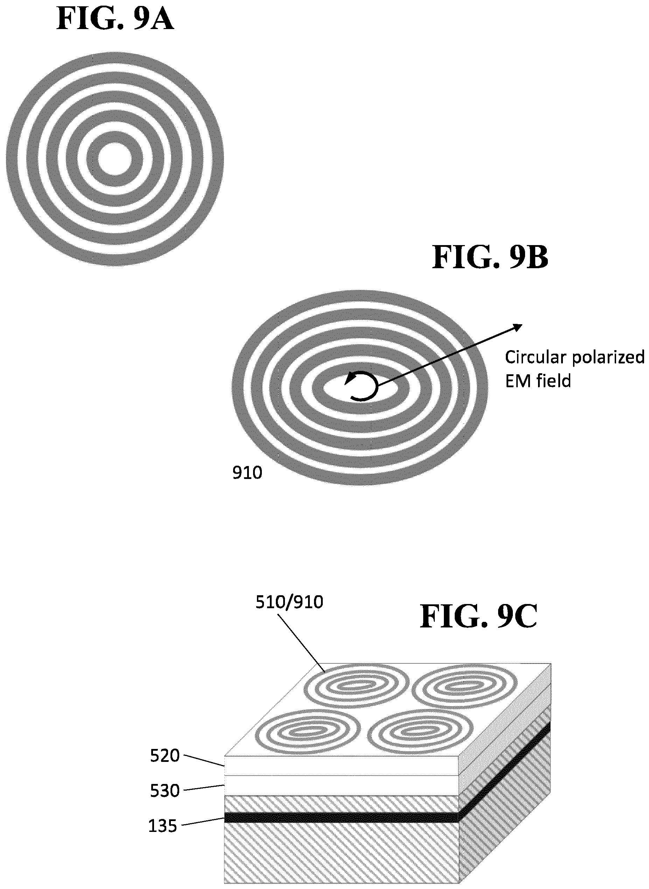

FIGS. 9A-9C show arrangements using a "bullseye" plasmonic structure. FIG. 9A shows a conventional circular structure; FIG. 9B shows an elliptical structure according to embodiments disclosed herein; FIG. 9C shows a device as previously disclosed herein with elliptical bullseye plasmonic structures included in the outcoupling layer.

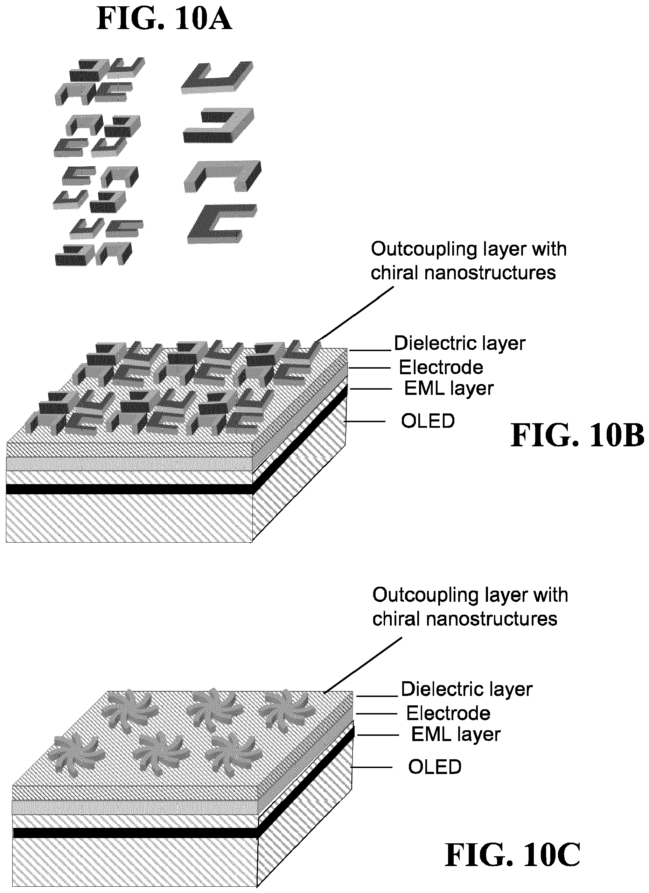

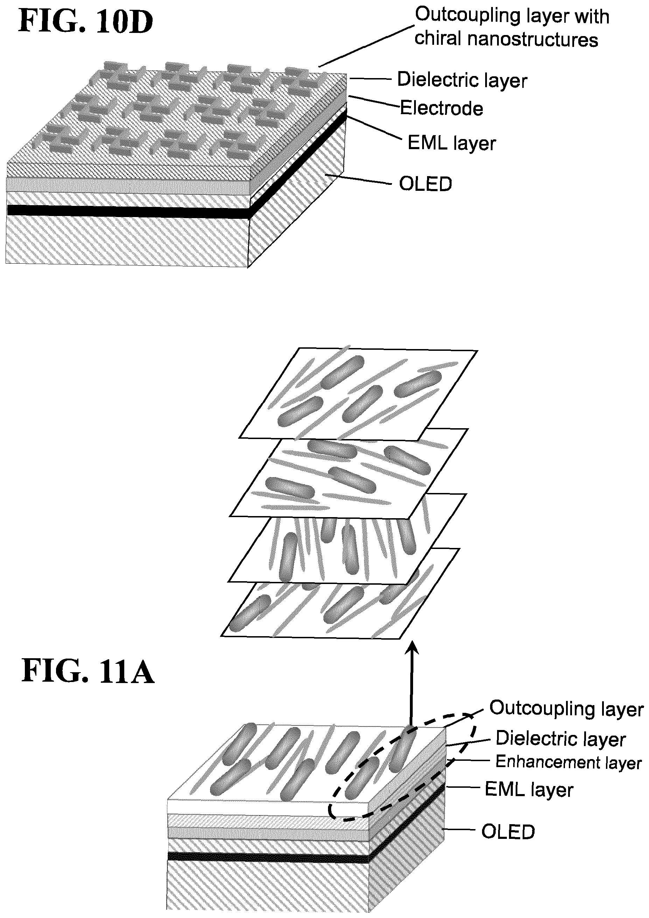

FIG. 10 shows an example of chiral metal nanostructures. to achieve circular polarized emission from OLED devices. FIG 10A shows 3D chiral plasmonic structures formed by a split ring resonator (SRR) as disclosed herein. FIGS. 10B-10D show examples of OLED devices using chiral plasmonic structures for outcoupling as disclosed herein, including arrays of unit cell made of SRRs in FIG. 10B, chiral shuriken plasmonic structures in FIG. 10C, and gammadion chiral plasmonic structures in FIG. 10D.

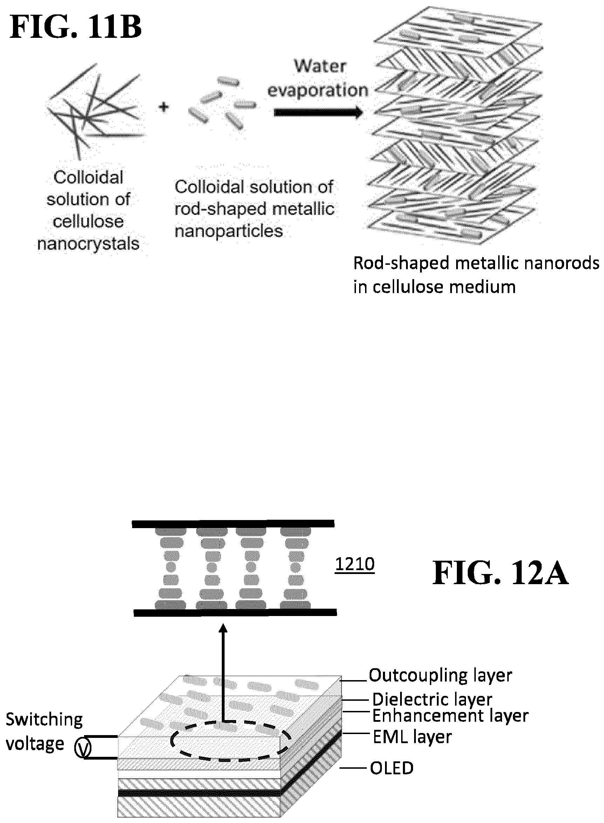

FIG. 11A shows a device as disclosed herein that includes a chiral arrangements of rod shaped metal nanostructures in a chiral medium formed by cellulose nanocrystals. FIG. 11B shows the schematic of nanoparticle alignment along the out of plane direction.

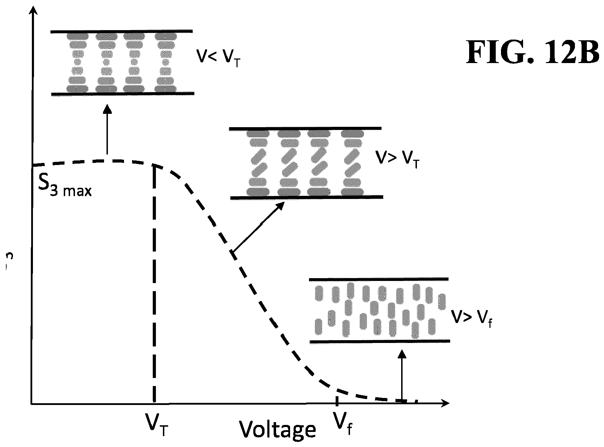

FIG. 12A shows an example of an OLED structure with metal nanostructures doped liquid crystal as outcoupling layer as disclosed herein. FIG 12B schematically illustrates the expected variations of Stokes parameter $S_3$ with voltage applied between the top and bottom of the outcoupling layer.

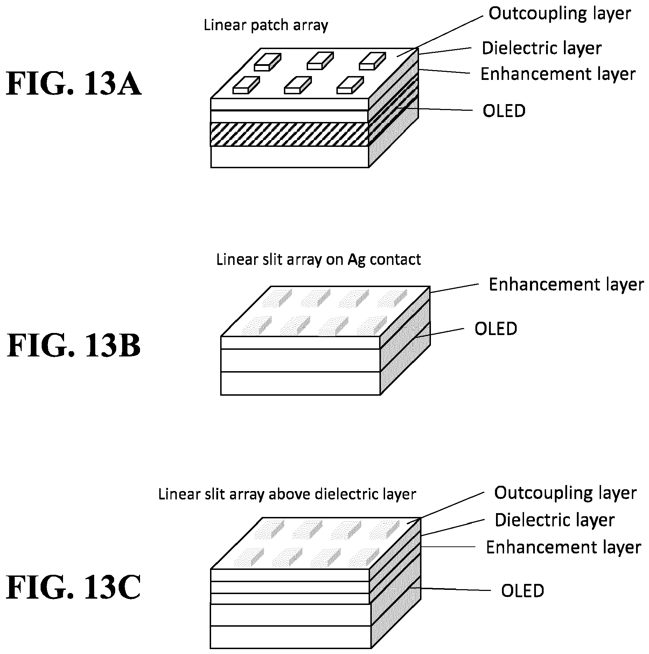

FIG. 13 shows device structures that generate linearly polarized emission according to embodiments disclosed herein, including arrays of rectangular shaped particles in FIG 13A, arrays of rectangular holes or recession in enhancement layer in FIG 13B and arrays of rectangular holes or recession in the outcoupling layer in FIG 13C .

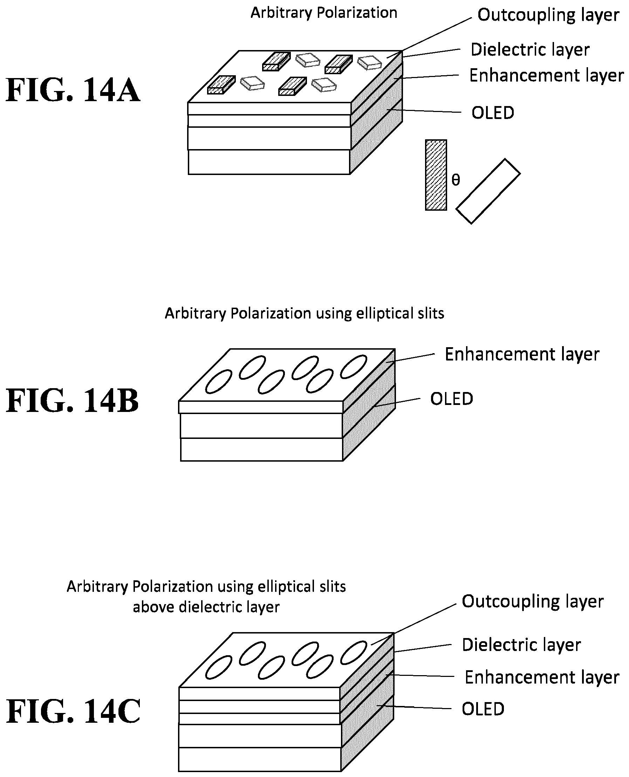

FIG. 14 shows examples of devices for generating arbitrary polarizations according to embodiments disclosed herein, including an outcoupling layer that includes unit cells of nanoparticles in FIG. 14A, elliptical nano holes or recession in the enhancement layer in FIG. 14B, and holes or recessions in the outcoupling metal layer in FIG. 14C.

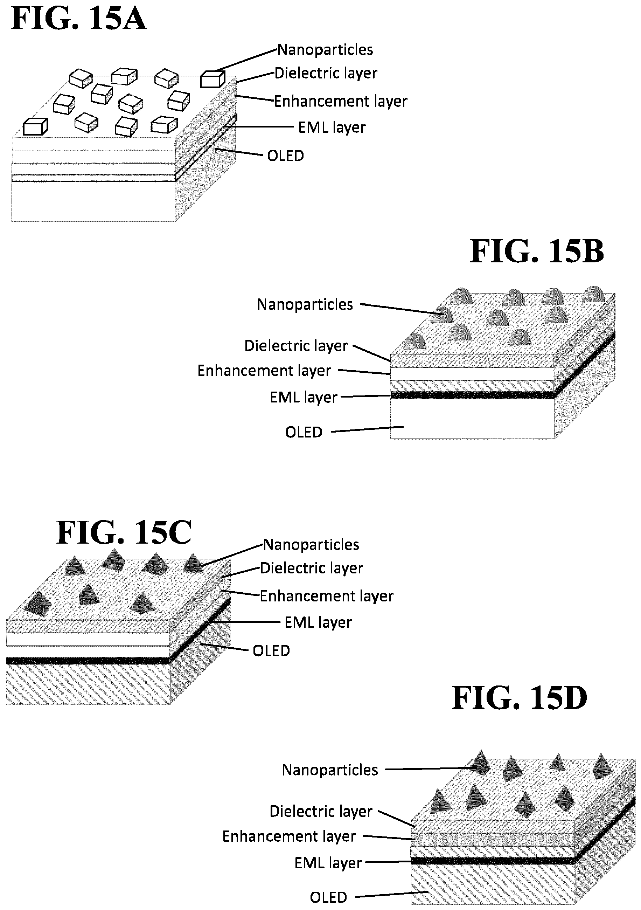

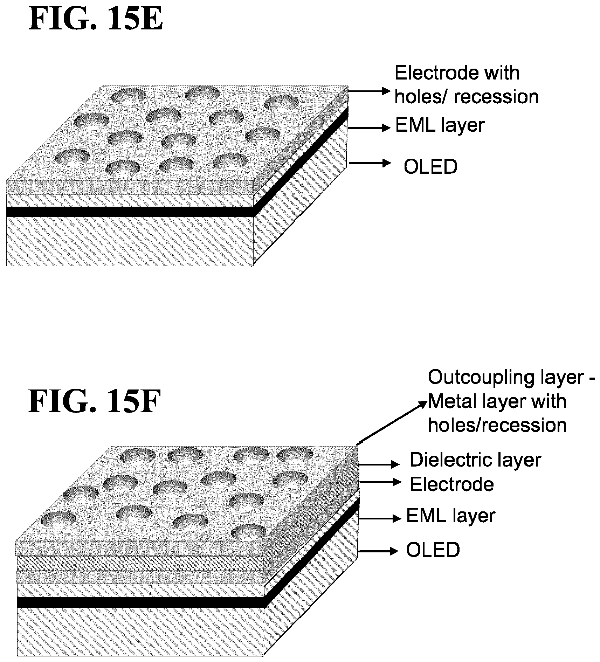

FIG. 15 shows examples of different outcoupling structures using metallic nanoparticles having various shapes for reducing the ambient reflections from OLED as disclosed herein, including nanocubes in FIG. 15A, nano hemispheres in FIG. 15B, square nano pyramids in FIG. 15C, and triangular nano pyramids in FIG. 15D. FIG. 15E shows examples of light outcoupling using holes or recessions in the enhancement layer. FIG. 15F shows examples of light outcoupling using holes or recessions in an additional metal layer above the enhancement layer. Such arrangements may be used to achieve unpolarized emission from the OLED device.

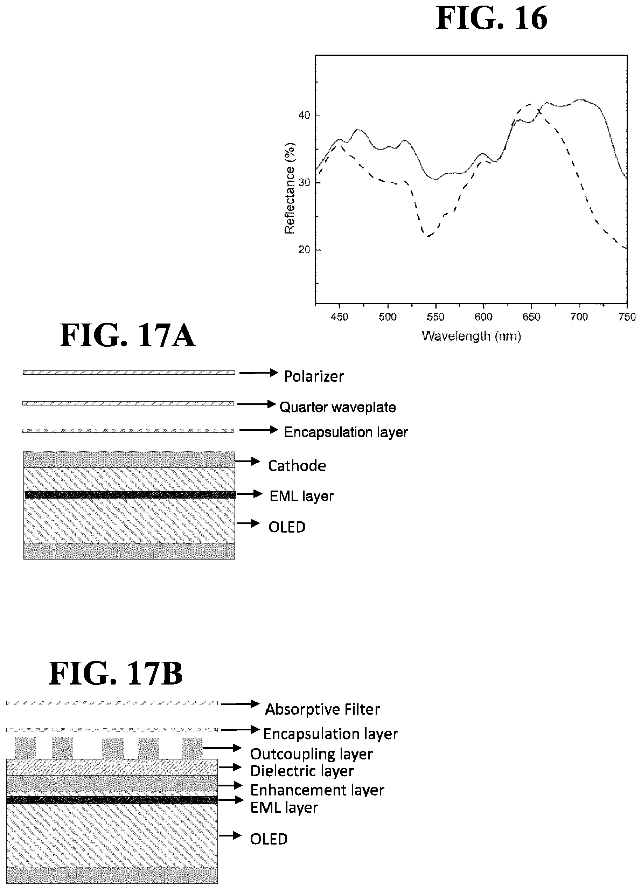

FIG. 16 shows simulated light reflectance from a plasmonic OLED device utilizing randomly distributed silver nanocubes with a 10 nm dielectric material of index 1.4 as the outcoupling layer for angle of incidence 45 ° (solid curve) and 60 ° (dashed curve) according to embodiments disclosed herein.

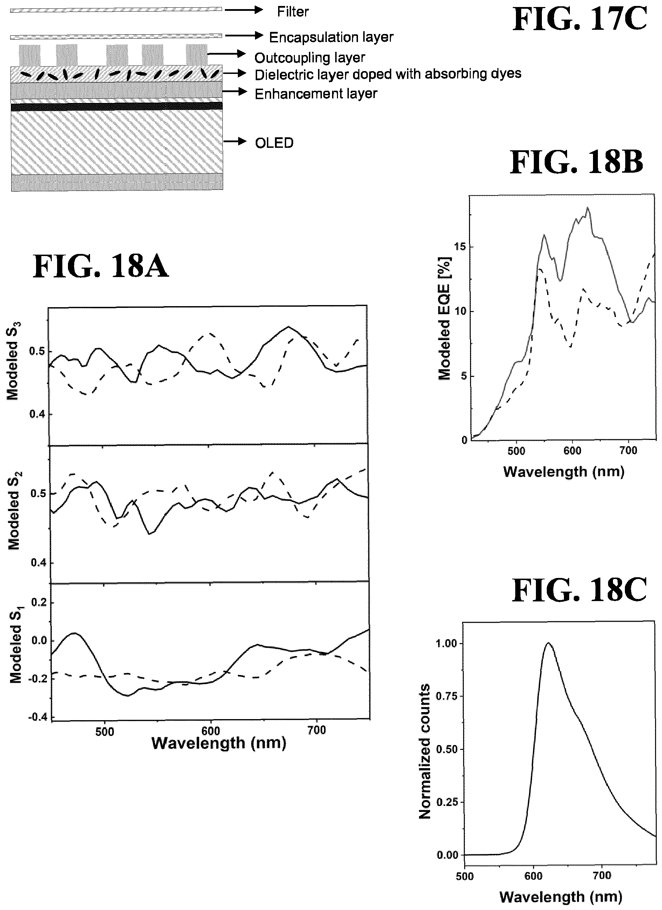

FIG. 17A shows a conventional plasmonic device. FIG. 17B shows a plasmonic device as disclosed herein, in which an outcoupling layer and dielectric layer are used to reduce ambient light. FIG. 17C shows a similar device in which the dielectric layer is doped with one or more absorbing dyes.

FIG. 18A shows estimated stokes parameters $S_1$, $S_2$ and $S_3$ for vertical (solid curve) and horizontal (dashed curve) alignment of a dipole emitter for a device having an outcoupling layer with a square array of two orthogonally arranged silver rectangular nano structures of different dimensions as disclosed herein. FIG. 18B shows the modeled EQE variations in the visible region for vertical (solid curve) and horizontal (dashed curve) alignment of the dipole emitter simulated for the same device. FIG. 18C shows the EL spectrum for a red dipole emitter used in the estimation of effective EQE values summarized in Table 2.

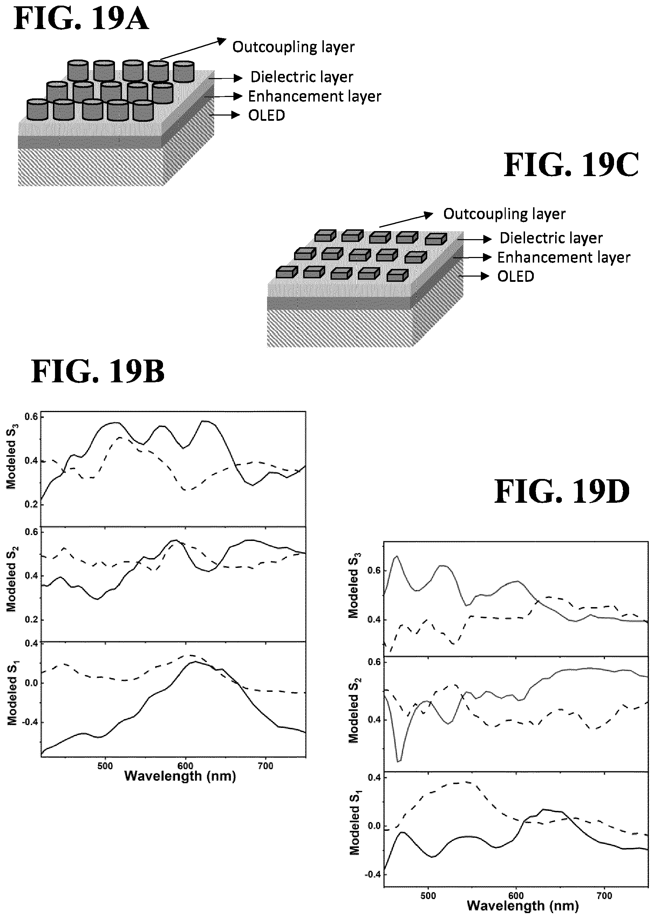

FIG. 19A shows schematic depiction of a device as disclosed herein that includes a rectangular array of circular nano pillars of silver as outcoupling layer. The radius and height of silver pillars are 50 nm and 100 nm respectively with array periodicity of 300 nm and 400 nm along two mutually orthogonal symmetry directions. FIG. 19B shows the estimated stokes parameters $S_1$, $S_2$ and $S_3$ for the vertical (solid curve) and horizontal (dashed curve) alignment of the emitter for the device shown in FIG. 19A. FIG. 19C shows a schematic representation of an OLED design as disclosed herein that includes a rectangular array of nano sized rectangular structures of silver as an outcoupling layer. The in-plane dimensions of the silver nano structures are 200 x 100 nm and height 100 nm. The lattice periodicity of the arrays along the longest and shortest dimension of the silver nano structures are 250 nm and 400 nm, respectively. FIG. 19D shows the estimated stokes parameters $S_1$, $S_2$ and $S_3$ for vertical (solid curve) and horizontal (dashed curve) alignment of the emitter for the OLED design shown in FIG. 19C.

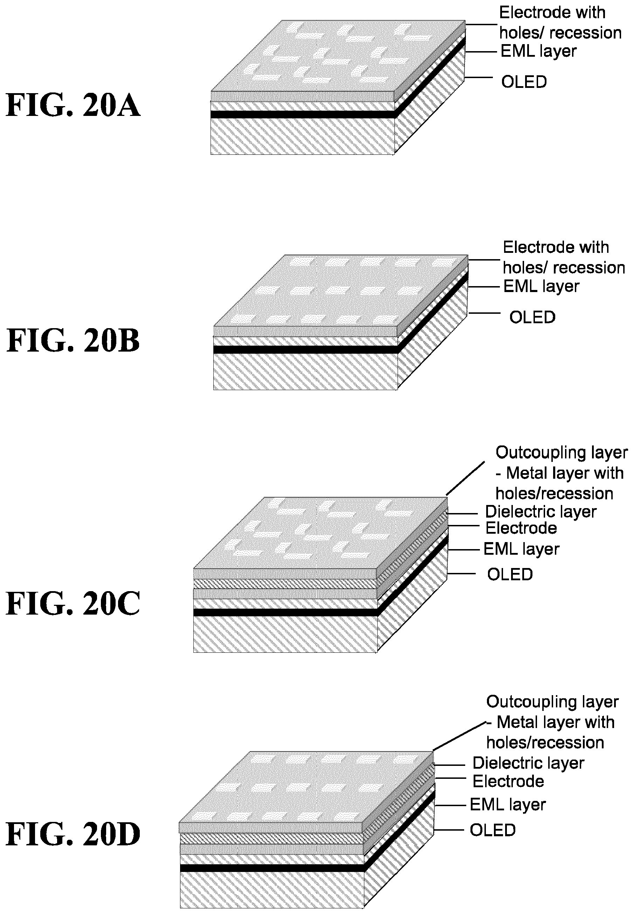

FIGS. 20A-20D show examples of device structures that generate circular polarized emission using holes or recession in the enhancement layer or outcoupling metallic layer disclosed herein. FIGS. 20A and 20B show the OLED structure with arrays of unit cells formed from pairs of orthogonally-oriented rectangular holes or recession in the enhancement layer and outcoupling metal layer, respectively. FIGS. 20C and 20D show examples of OLED structures with arrays of rectangular holes or recessions in the enhancement layer and outcoupling metal layer, respectively, arranged in a periodic lattice with different lattice periodicity in orthogonal directions.

## DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292, which is incorporated by reference in its entirety. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"), are incorporated by reference in their entireties. Phosphorescence is described in more detail in US Pat. No. 7,279,704 at cols. 5-6, which are incorporated by reference.

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with $F_4$-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. Barrier layer 170 may be a single- or multi-layer barrier and may cover or surround the other layers of the device. The barrier layer 170 may also surround the substrate 110, and/or it may be arranged between the substrate and the other layers of the device. The barrier also may be referred to as an encapsulant, encapsulation layer, protective layer, or permeation barrier, and typically provides protection against permeation by moisture, ambient air, and other similar materials through to the other layers of the device. Examples of barrier layer materials and structures are provided in U.S. Patent Nos. 6,537,688, 6,597,111, 6,664,137, 6,835,950, 6,888,305, 6,888,307, 6,897,474, 7,187,119, and 7,683,534, each of which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

In some embodiments disclosed herein, emissive layers or materials, such as emissive layer 135 and emissive layer 220 shown in FIGS. 1-2, respectively, may include quantum dots. An "emissive layer" or "emissive material" as disclosed herein may include an organic emissive material and/or an emissive material that contains quantum dots or equivalent structures, unless indicated to the contrary explicitly or by context according to the understanding of one of skill in the art. In general, an emissive layer includes emissive material within a host matrix. Such an emissive layer may include only a quantum dot material which converts light emitted by a separate emissive material or other emitter, or it may also include the separate emissive material or other emitter, or it may emit light itself directly from the application of an electric current. Similarly, a color altering layer, color filter, upconversion, or downconversion layer or structure may include a material containing quantum dots, though such layer may not be considered an "emissive layer" as disclosed herein. In general, an "emissive layer" or material is one that emits an initial light based on an injected electrical charge, where the initial light may be altered by another layer such as a color filter or other color altering layer that does not itself emit an initial light within the device, but may re-emit altered light of a different spectra content based upon absorption of the initial light emitted by the emissive layer and downconversion to a lower energy light emission. In some embodiments disclosed herein, the color altering layer, color filter, upconversion, and/or downconversion layer may be disposed outside of an OLED device, such as above or below an electrode of the OLED device.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos.

PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more intervening layer can be disposed between the enhancement layer and the outcoupling layer. The examples for intervening layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and in other embodiments the outcoupling layer is composed of a pluraility of nanoparticles disposed over a material. In these embodiments the outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer, and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the outcoupling layer also acts as an electrode of the device.

It is believed that the internal quantum efficiency (IQE) of fluorescent OLEDs can exceed the 25% spin statistics limit through delayed fluorescence. As used herein, there are two types of delayed fluorescence, i.e. P-type delayed fluorescence and E-type delayed fluorescence. P-type delayed fluorescence is generated from triplet-triplet annihilation (TTA).

On the other hand, E-type delayed fluorescence does not rely on the collision of two triplets, but rather on the thermal population between the triplet states and the singlet excited states. Compounds that are capable of generating E-type delayed fluorescence are required to have very small singlet-triplet gaps. Thermal energy can activate the transition from the triplet state back to the singlet state. This type of delayed fluorescence is also known as thermally activated delayed fluorescence (TADF). A distinctive feature of TADF is that the delayed component increases as temperature rises due to the increased thermal energy. If the reverse intersystem crossing rate is fast enough to minimize the non-radiative decay from the triplet state, the fraction of back populated singlet excited states can potentially reach 75%. The total singlet fraction can be 100%, far exceeding the spin statistics limit for electrically generated excitons.

E-type delayed fluorescence characteristics can be found in an exciplex system or in a single compound. Without being bound by theory, it is believed that E-type delayed fluorescence requires the luminescent material to have a small singlet-triplet energy gap ($\Delta E_{S-T}$). Organic, non-metal containing, donor-acceptor luminescent materials may be able to achieve this. The emission in these materials is often characterized as a donor-acceptor charge-transfer (CT) type emission. The spatial separation of the HOMO and LUMO in these donor-acceptor type compounds often results in small $\Delta E_{S-T}$. These states may involve CT states. Often, donor-acceptor luminescent materials are constructed by connecting an electron donor moiety such as amino- or carbazole-derivatives and an electron acceptor moiety such as N-containing six-membered aromatic ring.

Devices fabricated in accordance with embodiments of the invention can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the invention can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video walls comprising multiple displays tiled together, a theater or stadium screen, and a sign. Various control mechanisms may be used to control devices fabricated in accordance with the present invention, including passive matrix and active matrix. Many of the devices are intended for use in a temperature range comfortable to humans, such as 18 C to 30 C, and more preferably at room temperature (20-25 C), but could be used outside this temperature range, for example, from -40 C to 80 C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

In some embodiments of the emissive region, the emissive region further comprises a host.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence), triplet-triplet annihilation, or combinations of these processes.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

The organic layer can also include a host. In some embodiments, two or more hosts are preferred. In some embodiments, the hosts used maybe a) bipolar, b) electron transporting, c) hole transporting or d) wide band gap materials that play little role in charge transport. In some embodiments, the host can include a metal complex. The host can be an inorganic compound.

## COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

Various materials may be used for the various emissive and non-emissive layers and arrangements disclosed herein. Examples of suitable materials are disclosed in U.S. Patent Application Publication No. 2017/0229663, which is incorporated by reference in its entirety.

### Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

### HIL/HTL:

A hole injecting/transporting material to be used in the present invention is not particularly limited, and any compound may be used as long as the compound is typically used as a hole injecting/transporting material.

### EBL:

An electron blocking layer (EBL) may be used to reduce the number of electrons and/or excitons that leave the emissive layer. The presence of such a blocking layer in a device may result in substantially higher efficiencies, and or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and or higher triplet energy than one or more of the hosts closest to the EBL interface. In one aspect, the compound used in EBL contains the same molecule or the same functional groups used as one of the hosts described below.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

**HBL:**

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and or higher triplet energy than the emitter closest to the HBL interface. In some embodiments, the HBL material has a lower HOMO (further from the vacuum level) and or higher triplet energy than one or more of the hosts closest to the HBL interface.

**ETL:**

An electron transport layer (ETL) may include a material capable of transporting electrons. The electron transport layer may be intrinsic (undoped), or doped. Doping may be used to enhance conductivity. Examples of the ETL material are not particularly limited, and any metal complexes or organic compounds may be used as long as they are typically used to transport electrons.

**Charge generation layer (CGL)**

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

Current OLED display panels and similar devices as described above often use both a polarizer and a quarter wave plate to eliminate ambient light reflection from the display. However, this combination also decreases the brightness of the emitted light, typically by about 50%. Embodiments disclosed herein leverage the ability of an outcoupling structure using an enhancement layer to increase the fraction of light emitted by the pixel that passes through the polarizer and/or to decrease the amount of reflected ambient light. This allows for display panels that utilize these device requiring fewer or no additional polarization control elements. More specifically, embodiments disclosed herein provide high-efficiency plasmonic OLED-based displays by using the design of the plasmonic device to overcome some of the shortcomings that exist in a conventional display panel. Various embodiments include arrangements to provide control of the Stokes parameters of the emitted light, and/or modification of the ambient light incident on the device relative to the emitted light, to maximize the amount of light that a user can see from the OLED display.

Embodiments disclosed herein make use of, and may include, an enhancement layer as disclosed in U.S. Patent Nos. 9,960,386, 11,139,442, and 11,217,762, the disclosure of each of which is incorporated by reference in its entirety, and U.S. Patent Application Pub. Nos. 2021/0265584 and 2021/0249633, the disclosure of each of which is incorporated by reference in its entirety. As described in these publications, an "enhancement layer" refers to a layer that includes a plasmonic material exhibiting surface plasmon resonance that non-radiatively couples to an organic emissive material in the organic emissive layer or region and transfers excited state energy from the organic emissive material to a non-radiative mode of surface plasmon polaritons of the enhancement layer. As described in these related publications and with regard to embodiments disclosed herein, the enhancement layer may be an electrode of the device or it may be a separate layer. The enhancement layer may be disposed within a "threshold distance" from the associated emissive layer, where one threshold distance is defined as the distance at which the total non-radiative decay rate constant is equal to the total radiative decay rate constant. An OLED or similar device that uses an enhancement layer as defined herein and in these related publications may be referred to as a "plasmonic" OLED or device. Similarly, a display panel that incorporates such an enhancement layer may be referred to as a "plasmonic display."

The present disclosure provides two primary approaches to improving the efficiency of plasmonic displays. The approaches may be used individually or in conjunction with one another, though some optional configurations may be suitable for use only in one approach as disclosed. A first approach provides for devices and techniques that control the wavefront of emission from the OLED itself so that any polarization controlling structure for ambient light does not reduce as much of the emission from the OLED. The directionality of the emission also may be controlled, such as for applications in which it is desirable to increase or maximize the emission brightness in a selected direction. A second approach uses the outcoupling structure of the plasmonic OLED to reduce ambient reflections rather than utilizing an additional polarization controlling element. This also may simplify manufacturing of the display by eliminating additional elements that would otherwise need to be incorporated into the display.

The first approach, addressing polarization and directional control of OLED sub-pixels allows for light emission of any desired polarization (circular, linear or elliptical) by engineering the out-coupling structure in the OLED with an enhancement layer. Generally, the outcoupling energy in the form of light from the SPR (surface plasmon resonance) mode may be used to provide OLEDs that live longer at display brightness if the emissive layer is within a threshold distance of a plasmonically-active material, such as a metal cathode and/or anode (e.g., electrode layers) which serves as an enhancement layer as previously disclosed.

Embodiments disclosed herein may be used in conjunction with an enhancement layer, as previously disclosed, and the nanoparticle arrangement may be described in relation to such an enhancement layer. The placement of the light-emitting material in the vicinity of an enhancement layer, which can include metallic materials or other plasmonically-active materials, increases interactions with the surface plasmon polariton at the enhancement layer dielectric interface. The device is designed such that the non-radiative modes of the enhancement layer quench the light emitter. Light is subsequently created in free space by scattering the energy from the plasmonic modes of the enhancement layer through the use of an outcoupling layer. The enhancement layer may non-radiatively couple to fluorescent, delayed-fluorescent, and phosphorescent light emitting materials but is especially useful for phosphorescent light emitters due to their small radiative decay rate constant. Rapid de-excitation of the light emitting material via resonant energy transfer to the enhancement layer surface plasmon polariton is expected to increase the stability of the OLED.

An example embodiment may be considered in which the enhancement layer is a thin film of silver (Ag). This thin film of silver has a surface plasmon mode. The emissive material also may be in proximity to the silver film. For simplicity, the emissive material may be considered as a single emitting material but in various embodiments the emissive material can be, but is not limited to, layers of materials which are doped at high volume fractions of emissive material, neat layers of emissive material, an emissive material doped into a host, an emissive layer that has multiple emitting materials, an emissive layer in which the emission originates from a state formed between two materials, such as an exciplex or an excimer.

In an OLED, an important aspect of the emissive material is the photon yield which is also known as the photo luminescent quantum yield (PLQY). We can describe the photon yield as:

$$Photon\ yield = \frac{k_{rad}^{total}}{k_{rad}^{total} + k_{non-rad}^{total}}\quad(1)$$

where $k_{rad}^{total}$ is the sum of all the radiative processes and $k_{non-rad}^{total}$ is the sum of all the non-radiative processes. For an isolated emitter in vacuum, we can define the molecular radiative and non-radiative rates, $k_{rad}^0$ and $k_{non-rad}^0$ as the only radiative and non-radiative processes. For the isolated molecule the yield of photons is then

$$Photon\ yield^0 = \frac{k_{rad}^0}{k_{rad}^0 + k_{non-rad}^0}\quad(2)$$

Upon bringing an emissive material in proximity to the silver film, both the radiative and non-radiative rates may be modified as they are strongly dependent on the distance of the emitter from the interface between the metal and the dielectric medium in which the emitter sits. We can then re-cast equation (1) into equation (3) by adding the terms of $k_{rad}^{plasmon}$ and $k_{non-rad}^{plasmon}$ where $k_{rad}^{plasmon}$ is the radiative rate due to the presence of the Ag film and $k_{non-rad}^{plasmon}$ is the non-radiative rate due to the presence of the Ag film.

$$Photon\ yield = \frac{k_{rad}^{total}}{k_{rad}^{total} + k_{non-rad}^{total}} = \frac{k_{rad}^0 + k_{rad}^{plasmon}}{k_{rad}^0 + k_{rad}^{plasmon} + k_{non-rad}^0 + k_{non-rad}^{plasmon}}\quad(3)$$

This is shown in FIG. 3A, which schematically depict the total radiative and non-radiative rates for an emitter as a function of distance from the surface of the Ag film. The distance is the distance from the metallic film surface closest to the emissive layer to the emissive material. A dashed line marks the distance at which the radiative rate is equal to the non-radiative rate and is a threshold distance. At this threshold distance the photon yield is 50%. Further, this basic breakdown of rates shows why in typical OLED devices the emissive layer is positioned a large distance away from any plasmonically-active material. If the emissive layer is too close to the metal layer, the energy is coupled non-radiatively into the plasmon modes of the contact(s) and there is a reduction in the efficiency of the device. In our invention, we extract the energy that would otherwise be lost in the non-radiative mode of the thin Ag film as photons outside the device utilizing an outcoupling layer. Thus, we recover the energy coupled to the surface plasmon mode of the enhancement layer in our invention and it is beneficial, instead of deleterious, to enhance the amount of non-radiative coupling to the surface plasmon mode of the Ag film.

To understand how to maximize the efficiency of the enhancement layer devices in this invention, we utilize some assumptions about the relative dependence on distance for the plasmon radiative and non-radiative rates and break down the rate constants from FIG. 3A into the component rates as shown in FIG. 3B and described in Equation 3.

In FIG. 3B, the emitter's intrinsic radiative rate is plotted (solid line), as well as the radiative rate constant due to the emitter's proximity to the Ag thin film, which is $k_{rad}^{plasmon}$ in Equation 3 (double line). The emitter's intrinsic radiative decay rate is not dependent on the distance from the Ag film, $d$. However, $k_{rad}^{plasmon}$ is dependent on the distance from the Ag film, where here it is assumed to have a $1/d^3$ dependence. This is an illustrative example only and the actual dependence on distance can be a more complicated function, for example, when $d$ is less than 7 nm or when $d$ is on the order of the wavelength of emission divided by two times the index of refraction. Like the radiative rate, the non-radiative rate in vacuum of the emitter is not a function of distance from the Ag film. However, the non-radiative rate due to the presence of the Ag film, $k_{non-rad}^{plasmon}$, is dependent on the distance from the Ag film and has a stronger dependence on distance than $k_{rad}^{plasmon}$, namely, $1/d^6$.

The different dependencies on distance from the metallic film results in a range of distances over which the radiative rate constant due to interaction with the surface plasmon is the largest rate constant. For these distances the photon yield is increased over the photon yield of an isolated molecule far from the metallic surface, as shown in FIG. 4A. At these distances there is also a speed-up in the emission rate for the light emitting material. As $d$ is reduced from this point, the emitter is quenched into the non-radiative modes to the surface plasmon mode of the Ag film, and the yield of photons decreases below the limit of the isolated molecule. The point at which yield is reduced due to quenching to the surface plasmon mode is threshold distance 2. This is the minimum distance at which the photon yield is the same as the emitter without the enhancement layer. At distances below this threshold distance, there is an even larger speed up in the rate at which energy leaves the light emitter as the non-radiative rate exceeds the radiative rate for these distances. Importantly, in FIG. 4A, it is clear that excitons are the source of energy transferred to the enhancement layer as the photon yield is lowered by moving the emission layer closer to the Ag thin film. Obtaining a curve similar in shape to FIG. 4A clearly indicates that excitons in the OLED are the species being quenching by the addition of the enhancement layer. Further, FIG. 4A is only one embodiment of the shape of the curve. In some cases where the distance dependence of $k_{non-rad}^{plasmon}$ is more similar to $k_{rad}^{plasmon}$ there may only be a continuous drop in the photon yield as $d$ is reduced. Using the rate constants from above, we can specifically define the threshold distance 2 as the distance at which the following inequality is satisfied:

$$\frac{k_{rad}^0 + k_{rad}^{plasmon}}{k_{rad}^0 + k_{rad}^{plasmon} + k_{rad}^0 + k_{non-rad}^0} \leq \frac{k_{rad}^0}{k_{rad}^0 + k_{non-rad}^0} \quad (4a)$$

$$k_{non-rad}^{plasmon} \geq \frac{k_{non-rad}^0}{k_{rad}^0} k_{rad}^{plasmon} \quad (4)$$

Plainly, Equation 4a is the condition in which the PLQY when the enhancement layer is present is less than or equal to the photon yield without the enhancement layer. One knowledgeable in the art would not recommend operating when the photon yield is reduced as that typically reduces device efficiency. Equation 4 solves equation 4a for $k_{non-rad}^{plasmon}$ relative to the other rate constants. We can re-cast equation 4 explicitly utilizing the distance dependence of the plasmon rates as Equation 5:

$$k_{non-rad}^{plasmon}(d) \geq \frac{k_{non-rad}^0}{k_{rad}^0} k_{rad}^{plasmon}(d) \quad (5)$$

where d is the distance of the emitter from the surface of metallic film closest to the emitter.

Further, we can define a threshold distance 1 as the distance at which the emitter's photon yield is reduced to 50%. This threshold distance is the distance at which the total of the non-radiative rates from the emitter is equal to the total of the radiative rates of the emitter. Or plainly, the radiative rate of the emitter is equal to the non-radiative rate. Using the distance-dependent plasmonic rates and equation 3, we derive that the threshold distance 1 is when:

$$k_{non-rad}^{plasmon}(d) + k_{non-rad}^{0} = k_{rad}^{0} + k_{rad}^{plasmon}(d) \quad (6)$$

To determine threshold distance 1, if the enhancement layer does not radiate light, then one can simply grow an OLED, or comparable thin film representative examples, with the light-emitting material variable distances from the enhancement layer and determine at which distance the PLQY drops to 50%. If the enhancement layer has elements which enable outcoupling of light from the surface plasmon mode, these elements need to be removed to determine the threshold distance. It is important not to measure the relative increase or decrease in light output but the actual PLQY as the emission radiation pattern and absorption of the emitter can vary as the position of the emitter relative to the thin film of Ag is changed.

To determine threshold distance 2 as described by Equation 4, one should measure the temperature of the OLED. Since non-radiative quenching of the exciton generates heat instead of photons, the OLED will heat up. Very simply, the heat generated in the OLED will be proportional to the yield of non-radiatively recombined excitons:

$$Heat\ yield \propto \frac{k_{non-rad}^{total}}{k_{rad}^{total} + k_{non-rad}^{total}} \quad (5)$$

As the distance between the light emitter and the metallic film is varied, the total heat conduction of the OLED will remain essentially constant, however, the heat yield will vary greatly.

FIG. 4B schematically sketches the steady state temperature of the OLED as the distance between the light emitter and metallic film is varied for a fixed current density of operation. For large distances of the emitting layer from the metallic surface there is no enhancement of the radiation or non-radiative quenching. The temperature of the OLED depends only on the total current density of operation and the efficiency of the light emitting material. As the emitter is brought closer to the metallic layer, the radiative rate increases and the photon yield is increases, reducing the heat generated in the OLED and the OLED's temperature. For distances shorter than threshold distance 2, the excitons on the light emitter are quenched as heat and the OLED's normalized temperature increases. This depiction of the temperature of the OLED is true when the enhancement layer is not outcoupling a predetermined significant fraction of energy in the surface plasmon mode as light. If there is outcoupling as part of the enhancement layer or an outcoupling layer is used in the device, such a layer is to be removed to perform this measurement of the threshold distance.

There are two possible tests to determine if the light emitter is positioned where the radiative or non-radiative surface plasmon rate constant is dominant using temperature. The first is to measure the temperature of the OLED devices with variable distance of the light emitting material from the metallic film, thereby replicating the schematic curve in FIG. 4B. The second is to replace the metallic film in the device structure with a transparent conducting oxide that does not have a strong surface plasmon resonance. An example material is indium tin oxide (ITO). Measuring the temperature of the device with the ITO and with the metallic film, if the temperature of the OLED with the metallic film is increased over the ITO control, then the non-radiative rate is dominant and the emitter is within threshold distance 2 of the enhancement layer.

Non-radiative energy transfer to the plasmon mode here is defined as the process in which the exciton is transferred from the light-emitting material to the surface plasmon polariton (SPP), localized surface plasmon polariton (LSPP), or other terminology those versed in the art would understand as a plasmon, without emitting a photon. Depending on the dimensionality of the metallic film or the metallic nanoparticles this process can be called Forster energy transfer, Forster resonant energy transfer, surface resonant energy transfer, resonant energy transfer, non-radiative energy transfer, or other terminology common to those versed in the art. These terms describe the same fundamental process. For weakly emissive states, energy transfer to the SPP or LSPP may also occur through Dexter energy transfer, which involves the simultaneous exchange of two electrons. It may also occur as a two-step process of single electron transfer events. Non-radiative energy transfer is broadband, meaning that in some embodiments the enhancement layer is not tuned for a particular light emitting material.

Embodiments disclose herein do not utilize the radiative rate enhancement of the surface plasmon polariton but rather the non-radiative rate enhancement. Those knowledgeable in the art of OLEDs and plasmonics teach against energy transfer to the non-radiative mode of the surface plasmon polariton as that energy is typically lost as heat. Here we intentionally put as much energy as possible into the non-radiative and then extract that energy to free space as light using an outcoupling layer before that energy is lost as heat. This is a novel idea because it is a unique two-step process and goes against what those knowledgeable in the art would teach about the non-radiative modes of a surface plasmon polariton.

In an embodiment, the plasmonic OLED device includes a patterned outcoupling layer. The outcoupling layer may include metallic nanostructures, which may be arranged in random, quasiperiodic, or periodic arrays such that an increase in a specific type of polarization can be obtained as described in further detail herein. In some embodiments, the use of polarization control may be combined with the use of control over the wavefront to direct a polarized and direction beam into the far field.

U.S. Patent No. 11,139,442 describes an outcoupling layer that includes randomly-dispersed Ag nanocube structures used in conjunction with a Ag enhancement layer. However, the resulting emission does not have any preferred polarization and is not highly directional. Embodiments disclosed herein use a similar system that may include patterning the outcoupling layer to control the polarization of the light emission while simultaneously performing the role of out-coupling.

FIG. 5A shows an example of various arrangements of metal nanostructures may be used to create polarized far-field emission according to embodiments disclosed herein. As shown, different arrangements and types of nanostructures typically result in different polarizations of the emitted light. FIGS. 5B-5E show side views of similar devices. FIG. 5B shows the general structure of such a device. FIGS. 5C-5E show examples of three dimensional metal nanostructures, which includes structures with a thinner metal region at the middle as depicted in FIGS. 5C and 5D, or a metal-insulator-metal structure (MIM) as shown in FIG. 5E. As shown, the device may include a substrate 110 and an OLED 100 as previously disclosed, where the OLED includes one or more organic emissive materials disposed over an electrode. An enhancement layer 530 may be disposed over the OLED 100, or it may be incorporated within the OLED, such as where an electrode of the OLED 100 also serves as the enhancement layer. An outcoupling layer 510 as disclosed herein may be disposed over the OLED. The outcoupling layer may include an arrangement of metal nanostructures as disclosed in further detail herein, which may be embedded in a dielectric material or other material to form the outcoupling layer. The dielectric material in the outcoupling layer may have a refractive index of 1.4 or less, 1.6 or less, or 2 or less. In some embodiments, the outcoupling layer may have variable or non-uniform effective refractive indices across the layer, or it may have different effective refractive indices along two orthogonal directions, for example, parallel to the outer edges of the layer.

A dielectric layer 520 may be disposed between the outcoupling layer 510 and the enhancement layer 530 and/or the OLED 100. The dielectric layer may have a thickness measured perpendicular to the substrate of 150 nm or less, 100 nm or less, 50 nm or less, 30 nm or less, 20 nm or less, or 10 nm than less. The dielectric layer can be utilized to modify the coupling between the enhancement layer and the outcoupling layer, which modifies the efficiency. Further, the dielectric layer can be selected to assist in the phase shift required to modify the polarization of the light emitted by the outcoupling layer. Generally, adielectric layer thickness greater than 30 nm is preferred for polarization tuning, while less than 20 nm is preferred for reducing the ambient light reflection from the device. In addition to the thickness of the dielectric layer, the refractive index also plays a role in the efficiency, spectral response, and polarization control of the outcoupling layer. The refractive index of the material in the dielectric layer may be less than 2, less than 1.8, less than 1.6, or less than 1.4. Generally speaking, the higher the refractive index, the lower energy the outcoupling structures spectral response will be when all other aspects of the device are kept constant. Thus, dielectric materials with refractive index less than 1.5 are preferred for blue and green emitting OLED devices.

Metal nanostructures used in an outcoupling layer as disclosed herein may be formed from any suitable metal or alloy and may have various geometries as disclosed herein. Example materials that may be particularly suitable for metal nanostructures as disclosed herein include silver, gold, aluminum, pallidum, platinum, and combinations thereof. Silver is one of the least lossy metal for optical frequencies and the enhancement layer is preferably silver. However, to maximize polarization control or efficiency at different optical frequencies, the outcoupling structure may be chosen to be a different material. For example, gold nanoparticles have optical response in the red and near infrared and if designing for polarization control at these frequencies, the enhancement layer could be silver while the outcoupling structure metallic components are partially or fully comprise gold.

The device also may include a quarter-wave plate, a linear polarizer, and/or a color filter disposed over the outcoupling layer, for example to reduce ambient light reflected from various layers of the device, as disclosed in further detail herein. For example, where the OLED arrangement is used to provide sub-pixels and/or pixels in a display panel, the quarter-wave plate, linear polarizer, and/or color filter may be uniform layers disposed over the entire active area or a selected portion of the active area of the display panel.

The enhancement layer may include any suitable plasmonic material as described in the related publications. In some embodiments, silver, gold, aluminum, palladium, and/or platinum may be preferred.

In some embodiments, it is desired to generate light that is preferentially circularly polarized. Circularly polarized light can be generated using both achiral and chiral metal nanostructures. FIG. 6A shows an enlarged view of a portion of such a device that uses achiral metal nanostructures arranged in unit cells as disclosed herein. FIG. 6B shows the general device structure including the achiral metal nanostructures.

To generate circular polarization, rectangular metal nanostructures may be arranged in unit cells including two nanostructures, which are arranged with their major axes orthogonal to one another as shown in FIG. 6A. That is, the nanostructures may have the general shape of a regular solid prism, such as a rectangular prism, and may be arranged such that the major axis of pairs of nanostructures in each unit cell are perpendicular or non-parallel, depending upon the desired degree(s) of various types of polarization as disclosed herein. In some embodiments, it may be desirable for the edge-to-edge separation between pairs of nanostructures to be shortest when measured between the closets ends of the pair of nanostructures. Depending on the desired degree and type of polarization, it may be desirable for the pairs of nanostructures in the unit cells to be arranged such that their major axes have an inner angle of 75-90°, 30-60°, less than 30°, or 60° or more.

In some embodiments, the metal nanostructures may have a non-uniform shape and/or composition. For example, the nanostructures may have a non-uniform cross section along a direction perpendicular to the substrate. Examples of such a structure are shown in FIGS. 5C and 5D, but more generally any non-uniform regular or non-regular structure may be used, where a "regular" structure refers to a shape that can be formed via rotation of a well-defined curve around a line such as a central axis of the structure. The nanostructures also may have a non-uniform composition in a direction parallel to the substrate, for example where the relative proportion of one or more materials in the nanostructures is in a gradient. As another example, the nanostructures may have a composition that includes one or more dielectric materials and the relative proportion of the material is non-uniform along a direction perpendicular to the substrate.

The metal nanostructures may have any desired shape, regular or irregular, including spherical, cylindrical, rectangular, cubical, hemispherical, star-shaped, hexagonal, or the like, or an assortment of irregular and/or random shapes and dimensions. The nanostructures may have in-plane dimensions of 50-500 nm, or at least 100 nm, at least 150 nm, or at least 250 nm. As used herein, the in-plane dimension refers to a largest dimension of the nanostructure measured within the outcoupling layer, measured in any direction parallel to the plane of the substrate. Conversely, the nanostructures may have out-of-plane dimensions of at least 100 nm, at least 150 nm, or at least 250 nm. As used herein, the out-of-plane dimension refers to the "height" of the nanostructure, i.e., its largest dimension measured in a direction perpendicular to the substrate.

The two metal nanostructures have resonances that are spectrally shifted as shown in FIG. 6C. The nanostructures are arranged to generate a $\pi/2$ phase shift between the fields generated between the metal nanostructures in each unit cell, creating a circular-polarized region in the region between the two nanostructures as shown. The pair of nanostructures may be arranged in ordered arrays, i.e., rows and columns of unit cells, or they may be placed arranged unordered or randomly in the outcoupling layer, which typically is disposed over and immediately adjacent to a dielectric layer. The light that outcouples to free space in such an arrangement will be preferentially circularly polarized. Other light that will be outcoupled by the outcoupling structure may not be circularly polarized as it doesn't experience a $\pi/2$ phase. However, the total emission measured will have a net circular polarization due to the outcoupling of some circularly polarized light along with some non-circularly polarized light. As described in further detail herein, it may be circularly polarized with a Stokes parameter $S_3$ having an absolute value of 0.1 or greater, more preferably between 0.1 and 0.5, more preferably between 0.5 and 0.75, or more preferably between 0.75 and 1, where a larger portion of circular polarized light is desired.

More generally, any two nanostructures, whether metallic or including other materials, which can be arranged to generate a $\pi/2$ phase shift between the orthogonal polarized components of the electric field in the local region of the device, will generate light that is partially or preferentially circularly polarized. Further, even if a full $\pi/2$ phase shift cannot be obtained, smaller phase shifts can result in preferential polarizations of light that would increase the brightness of the pixel after passing through polarization controlling optics. In some embodiments, the orientation of a quarter waveplate and a polarizer in the display panel can be adjusted to increase or maximize the EL light output from the panel, while maintaining a 45° relative orientation between the fast axis of the quarter waveplate and the polarizer to ensure minimal ambient light reflection from the device. Accordingly, if the angle between the nanostructures is not orthogonal, the nanostructures still will result in a net polarization of the light emitted by the OLED.

The polarization of light can be quantified using Stokes parameters. For a plasmonic device as disclosed herein, the Stokes parameters values may be estimated from a polarimetry analysis of emitted light from the OLED device. FIG. 7 shows examples of an experimental setup for measuring the Stokes parameters of an OLED device as disclosed herein. The arrangement utilizes a quarter waveplate, a polarizer, and a photodiode to analyze the light intensity. The orientation of the quarter waveplate is fixed with the fast axis aligned parallel to the x axis and linear polarizer is rotated through an angle θ. The light intensity variation for a beam of light passing through a waveplate and a polarizer can be expressed in terms of Stoke's parameters as follows

$$I(\theta, \varphi) = \frac{1}{2}(S_0 + S_1 cos2\theta + S_2\ sin2\theta\ cos\varphi + S_3\ sin2\theta\ sin\varphi)$$

where $I(\vartheta, \varphi)$ is the light intensity for polarizer orientation $\vartheta$ and phase retardation $\varphi$ introduced by the waveplate, and $S_0$, $S_1$, $S_2$ and $S_3$ are the conventional Stoke's parameters for polarized light. The quarter waveplate introduces a phase shift $\phi = \pi/2$ between the orthogonal polarized component of the light.

To measure the Stoke's parameters, the electroluminescent (EL) intensity is measured for polarizer orientations of $\theta = 45°$ and $90°$ with and without the quarter waveplate in the beam path. The intensity variation can be expressed as

$$I(0°, 0°) = \frac{1}{2}(S_0 + S_1)$$

$$I(45°, 0°) = \frac{1}{2}(S_0 + S_2)$$

$$I(90°, 0°) = \frac{1}{2}(S_0 - S_1)$$

$$I(45°, 90°) = \frac{1}{2}(S_0 + S_3)$$

Solving these equations yields the Stoke's parameters:

$$S_0 = I(0°, 0°) + I(90°, 0°)$$

$$S_1 = I(0°, 0°) - I(90°, 0°)$$

$$S_2 = 2I(45°, 0°) - S_0$$

$$S_3 = 2I(45°, 90°) - S_0$$

where $S_0$ signifies the total EL intensity, $S_1$, and $S_2$ represent the linear polarized components, and $S_3$ represents the circular polarized components of the EL emission. When normalized with the total light intensity, the values of $S_1$, $S_2$ and $S_3$ vary between -1 and 1, such that $S_1^2 + S_2^2 + S_3^2 = 1$, where $S_1$, $S_2$ and $S_3$ signifies the light intensity fraction of linearly polarized vertical components, linearly polarized components having a 45° alignment, and circular polarized components of the EL emission from the OLED device. Accordingly, the absolute value of $S_3$ indicates the degree of circular polarization of the emitted light, which in turn results in differences in the brightness of light emitted by the device as shown in Table 1.

Table 1. Expected improvements in OLED panel brightness for different ranges of $S_3$ values assuming the OLED EL emission passes through a quarter wave plate and a linear polarizer.

| Absolute value of $S_3$ | Effect on OLED brightness with a quarter wave plate and linear polarizer |
|---|---|
| $0.1 < S_3 < 0.5$ | The EL emission will contain either elliptically polarized or circularly polarized light with predominantly unpolarized or linear polarized components. Almost 100 % of the circularly polarized and a large fraction of elliptically polarized components will be transmitted through a circular polarizer, resulting in an enhancement of the brightness of the OLED panel. |
| $0.5 < S_3 < 0.75$ | The EL mission will be predominantly circularly or elliptically polarized leading to significant enhancement in the device brightness with the possibility of a brightness increase up to 1.75 times. |
| $0.75 < S_3 < 1$ | The EL emission is significantly circularly polarized. This is the most preferred embodiment for the polarization control layers in the panel.. The enhancement in the brightness value can range from 1.75 to a maximum of 2 for when absolute value of $S_3 = 1$. |

For a perfectly circular polarized emission $S_3 = \pm 1$, where +1 indicates a right circular and -1 a left circular polarized light. Although $S_3 = \pm 1$ is ideal for the device performance where the EL passes through quarter wave plate and linear polarizer. As shown in Table 1, embodiments disclosed herein may achieve emission having a Stokes parameter $S_3$ with an absolute value of 0.1 or greater, leading to increased brightness of the device, even where the device includes a quarter wave plate and/or a linear polarizer. Importantly, although in some embodiments an $S_3$ value of $\pm 1$ is ideal for OLED panels with a quarter waveplate and linear polarizer, it may not be ideal for other OLED panels where the polarization control optics are different. In that case, the outcoupling structure of the OLED device may be designed to generate light with a different Stokes parameter as disclosed herein.

In an embodiment, non-chiral metal nanostructures may be used to generate circular polarized emission. Periodic arrays of symmetric or asymmetric shaped metal nanostructures are arranged in the outcoupling layer with different periodicity in two orthogonal directions as shown in FIGS. 8A-8E. This method of wavefront control utilizes the collective modes in the metal nanostructure arrays to achieve the polarization control at desired wavelength range. FIGS. 8A-8E schematically illustrates how the polarization control is achieved. FIG. 8A shows a perspective view of the basic device structure, which has the same basic structure as the arrangements previously shown in FIGS. 5-6. FIG. 8A shows a perspective view of the device, which includes an outcoupling layer 510 including metal nanostructures, a dielectric layer 520, and enhancement layer 530, which may also function as an electrode of the OLED 100. The OLED 100 may include any conventional OLED structures as previously disclosed, including one or more emissive layers 135.

In another embodiment, the collective plasmon resonance of the nano particle arrays in the outcoupling structure are utilized to generate polarized emission. The collective resonance of the nanoparticle arrays depends on the array periodicity of the metal nanostructures in the outcoupling layer, the resonances in orthogonal directions (e.g., horizontal and vertical ordering directions) will be different. FIG. 8B shows an example of an array of nanostructures having different periodicity between adjacent nanostructures in two orthogonal directions 810, 820. More generally, it may be desirable for the nanostructures in the outcoupling layer to be arranged in a periodic lattice that has different periodicities (i.e., distances between adjacent nanostructures) in two orthogonal directions. In such an arrangement, the nanostructures are arranged in a grid-type structure that can be described as having a number of rows of nanostructures or unit cells, each row having the same number of nanostructures or unit cells arranged in columns. A phase difference of $\pi/2$ is introduced in the wavelength regions between these two modes. Furthermore, the resonance wavelengths can be tuned by changing the dimension of the metal nanostructures to more asymmetric shapes as shown in FIG. 8C. Adding high index dielectric blocks below the metal nanostructures or in the gaps between the metal nanostructures, also provides additional tunability through the strong gap plasmon modes that exists in the regions between metal nanostructures. Additionally, if high index dielectric blocks are added between the metal nanostructures, then the periodicity of the nanoparticles themselves may be constant in both orthogonal directions as the phase shift will be introduced by the variation of dielectric constant between the nanoparticles. In other embodiments, the high index dielectric material is utilized in addition to the different periodicities in orthogonal directions for the nanoparticle array in the outcoupling layer. FIG. 8D shows an arrangement in which a dielectric material 830 is disposed between adjacent metal nanostructures along one of the orthogonal directions, i.e., within each row or column of the array of nanostructures. A dielectric layer 520 may be disposed below the array of nanostructures and dielectric material as previously disclosed, or it may be omitted. FIG. 8E shows an arrangement in which the dielectric layer 520 is disposed only below the metal nanostructures.

In an embodiment, the lattice of nanostructures may have rows and/or columns that have different compositions and/or physical dimensions than each other. For example, the lattice may include a number of rows or columns, within which each nanostructure has the same or essentially the same composition and/or physical dimensions, but which differ from one or more other rows or columns in the lattice.

In an embodiment, the asymmetric effective dielectric constant of the ordered metal nanostructure arrays may be used to achieve polarization control. In this case the particle sizes and array periodicity should be about an order of magnitude lower than the wavelength of light, where the scattering efficiency of the particles are significantly lower. In some embodiments, it may be desirable for the nanostructures to have a largest axis of 10 nm or less, 25 nm or less, or 50 nm or less. Nano particles of silver, gold, aluminum or palladium of shapes spherical, cylindrical, star-shaped plates, hexagonal-shaped plates and random shaped structures may be used. The optical response of the periodic arrays in such an arrangement can be approximated by an effective medium approach. As the effective refractive index depends on the volume fraction of the particles, the arrays can now show optical birefringence due to the different effective refractive index in two orthogonal ordering directions 810, 820. Optimization of periodicity and material properties of the metal nanostructures also allows for control of the phase difference between the two orthogonal polarization components of the EL emission and realize the transmission properties in a similar fashion to a quarter-wave plate. For example, nanoparticles in the outcoupling layer may be arranged in ordered arrays with rows and columns, with interparticle spacing along each rows an order of magnitude lower than the spacing along columns can results in strong optical birefringence for the outcoupling layer. The magnitude of the birefringence depends on the nanoparticle shape, size and materials. Additionally, the nanoparticle arrays can be embedded in a dielectric material to tune the average refractive index of the outcoupling layer. The refractive index of the dielectric material may be less than 1.4, less than 1.6, or less than 2. Polymeric materials such as Polystyrene, polymethyl methacrylate, Poly vinyl pyrrolidone, Polylactic acid, Polyethylene terephthalate, Polycarbonate, metal oxides such as magnesium fluoride, aluminum oxide, and/or silicon dioxide, may be used as the dielectric medium. Use of such metal nanostructure arrays in the outcoupling layer along with other optical elements may simplify the OLED design significantly.

In an embodiment, bullseye plasmon structures may be used for polarization control. Conventional plasmonic bullseye structures are circular gratings of metal or dielectric structures, with an aperture at the center. Phase anisotropy for the light transmitted through the bullseye structures may be introduced by making the gratings and aperture elliptical rather than circular as shown in FIG. 9. FIG. 9A shows a conventional circular structure; FIG. 9B shows an elliptical structure according to embodiments disclosed herein; FIG. 9C shows a device as previously disclosed herein with elliptical bullseye plasmonic structures included in the outcoupling layer. A $\pi/2$ phase difference between two orthogonal components of the transmitted light can be achieved by tuning the dimensions of groves and rings as well as the ellipticity of the bullseye structure. A device design may include multiple elliptical bullseye structures as or within the outcoupling layer above the dielectric layer as shown in FIG. 9C. The overall device structure is the same as previously disclosed, i.e., a dielectric layer 520 disposed between the enhancement layer 530 and the outcoupling layer 510, which couples to the OLED including an emissive layer 135. The device includes an outcoupling layer 510 that incorporates or consists of microstructures having the elliptical bullseye structure 910 shown in FIG. 9B.

In an embodiment, chiral metal structures may be used for outcoupling as shown in FIG. 10. In these embodiments, the circular polarization field is generated by the chiral metal nanostructure itself. This means that the inherent electric field configuration of the nanoparticle adopts a phase shift as the nanoparticle outcouples light from the enhancement layer. FIGS. 10A-10D show examples of chiral plasmonic structures which may be used in the outcoupling layer. Metallic nanoparticles with surface plasmon resonance have been demonstrated to show ability to manipulate the chiro optical properties at nanoscale. The chiral plasmonic structures with few examples shown in Figure 10, can induce strong circular dichroism through the collective plasmon resonances. The metallic structures within a single nanoparticle are arranged geometrically and spatially to have enhanced collected resonances for a particular handedness, which enables the control of helicity of the outcoupled light from the device. Since light is reciprocal, it is also possible to suppress one handedness for the incoming or emitted light. The handedness of the chiral plane wave generated is determined by the rotation direction of the EM field around the propagation axis. FIG. 10A shows the schematics of three-dimensional chiral plasmonic structures utilizing split ring resonators (SRR). The structures can be arranged in a unit cell with four SRRs each rotated by 90° in the clockwise or anticlockwise direction to enhance the right circular polarized or left circular polarized emission from the device respectively. The unit cells of SRRs may be arranged with same orientation in an array with positional order or with random position order in the outcoupling layer as shows in FIG 10B. Alternatively, each SRR or unit cells of SRRs may be stacked in the out of plane direction, i.e. normal to the surface, with each layer rotated 90° with respect to the bottom layer as shown in FIG 10A. FIGS. 10C and 10D show schematic of an OLED device utilizing chiral shuriken and gammadion chiral plasmonic structures.

Alternatively, a chiral arrangement of metal nanostructures can be used within or as an outcoupling layer as previously disclosed. In this case, each particle itself does not have to be chiral, but the metal nanostructures are assembled into a chiral structure. An example of such a device is shown in FIG. 11A, in which the chiral structure is achieved by incorporating the colloidal metal nanostructures in a cellulose nanocrystal medium. FIG. 11B shows a process for creating such a layer, in which cellulose nanocrystals self-assemble to form a chiral nematic phase when evaporated from the solvent. The rod-shaped metal nanostructures dispersed in the medium aligns spontaneously with the cellulose nanocrystals, following the intrinsic chiral ordering that exists in the medium, as shown. The thin films of composite material show enhanced circular dichroism properties due to the presence of metal nanostructures in the medium. When used as an outcoupling layer for OLEDs, the energy from the enhancement layer would couple to the metal nanostructures, enhancing the light outcoupling from the device, while generating circularly polarized EL emission. The helicity of the EL emission depends on the handedness of the metal nanostructure ordering.

In an embodiment, a chiral arrangement of metal nanostructures is prepared by doping a chiral nematic thermotropic liquid crystal with rod shaped metal nanostructures, which can be used as the outcoupling layer in the plasmonic OLEDs as disclosed herein. The chemically synthesized rod-shaped metal nanostructures can be functionalized with suitable surface ligands to reduce the aggregation and to promote the uniform alignment with respect to the liquid crystal molecular ordering direction. The metal nanostructures dispersed in the liquid crystal medium follows the chiral alignment of the molecular host as shown in the exploded view 1210 in FIG. 12A, which can be affected by an external electric field. For example, a 1 kHz AC voltage of 10V or less may be applied to the device, such as across an outcoupling layer as disclosed herein, to control polarization of the emission. Frequencies in the range of 1 KHz to 10 KHz may be preferred for applications involving requiring continuous repeated switching of polarization.

The collective optical properties of the composite material can be controlled with electric field, providing the electrical tunability to the light outcoupling and polarization control as show in FIG 12B. For electric field values above a threshold voltage $V_T$, the torque induced by the external electric field, perturbs the chiral ordering of the liquid crystals, which in turn affect the nano particle ordering and tend to align parallel to the electric field direction. With increase in voltage more nano particles will have alignment parallel to the electric field, which effectively reduces the circular polarized component of the outcoupled light. For voltages above $V_f$ all the nanoparticles in the medium will have orientation parallel to the electric field, and emission will be completely unpolarized. The variation of polarization with voltage and the values of $V_T$ and $V_f$ depends on liquid crystal cell dimension, liquid crystal material, nano particle size and nano particle materials. Unlike the cellulose based plasmonic composites, liquid crystal composites are liquids and require design modifications to confine them above the enhancement layer of OLEDs, as shown in FIG. 12A.

In an embodiment, the circularly polarized light is generated by utilizing holes in the enhancement layer. In another embodiment the outcoupling layer is a thin film of metal with holes and optionally a dielectric layer disposed between them, which serves as an outcoupling layer as shown in FIGS. 20A-20D. Since the holes in metallic layer exhibits plasmon resonance properties identical to metal nanoparticles, the hole arrays can show polarization tuning properties similar to nanoparticle arrays. For example, the arrays may generate a phase shift which generates at least partially circularly polarized light and the holes in the metal layer may be arranged in a periodic lattice with different periodicity in orthogonal directions. Alternatively, or in addition, the enhancement layer and/or the additional metal layer may include one or more recessions, i.e., areas where the material of the enhancement layer is thinner but where the recession does not extend fully through the enhancement layer to form a hole. Holes and/or recessions in the enhancement layer may have a variety of shapes and dimensions, including elliptical, rectangular, circular, hexagonal, and irregular shapes. In some embodiments, to induce circular polarized emission, rectangular holes or recession are arranged in a unit's cell with each unit cell comprising a pair of holes or recession arranged such that the long axes are perpendicular to each other and the edge-to-edge separation between the pair of holes or recessions is shortest between closest ends of the pair as shown in FIGS. 20A-20D. The holes or recession may have in-plane dimensions of 50-500 nm, or at least 100 nm, at least 150 nm, or at least 250 nm. The depth of the recession may be 10-50 nm, or at least 10 nm, at least 2 nm, or at least 40 nm, depending on the thickness of the enhancement layer or the metal layer disposed above the dielectric layer which form the outcoupling layer.

In an embodiment, linearly polarized light is generated for polarization control. Examples of structures that may be used to generate linearly polarized emission include an array of metal nanostructures, a patterned enhancement layer that includes holes, or an additional metallic layer with holes or above the dielectric layer as shown in FIGS. 13A-13C. Nanoparticles or holes with rectangular shapes may be arranged in an ordered array with the long axes parallel to each other as show in FIGS. 13A-13C. The lattice periodicity of the array may be tuned such that the interparticle spacing between the particles are at least twice the long axis length of the particles or holes. In some embodiments, the positions of the nanoparticle or holes may have random distribution, while maintaining the parallel orientation of the nanoparticles or holes and average interparticle spacing at least twice the long axis length of the particles or holes. Alternatively, or in addition, the enhancement layer may include rectangular shaped recessions, i.e., areas where the material of the enhancement layer is thinner but where the recession does not extend fully through the enhancement layer to form a hole or slit. In such a device, the metal nanostructures or holes preferentially enhance one of the linear polarizations depending on their orientation. For example, in an arrangement that includes nano holes within the enhancement layer, a linearly-polarized preferential Purcell enhancement is also expected within the emissive layer. This means that some of the dipoles within the layer will have a larger rate decay enhancement (Purcell value) than others. . The linear polarized emission from the OLED can be characterized using Stokes parameters $S_1$ and $S_2$, which represents the vertical polarization state and 45° inclined to the vertical direction respectively. For a perfectly linear polarized emission

$S_1$ or $S_2 = \pm 1$. For OLED device which emits predominantly linear polarized emission, the absolute values of $S_1$ or $S_2$ will be at least 0.5.

More generally, to obtain arbitrary polarizations of the emitted light, a structure similar to the structure shown in FIG. 6 may be used, in which two metal nanostructures forms a unit cell. Alternatively or in addition, the enhancement layer may include nano sized holes of elliptical geometry and/or a metallic layer having elliptical holes may be disposed above the dielectric layer to form a polarization controller. Examples of a unit cell arrangement and elliptical nano sized holes suitable for generating arbitrary polarizations are shown in FIG. 14. In arrangements that use unit cells of nanostructures, the angle between the two metal nanostructures dictates the ellipticity of the light generated. Alternatively or in addition, the enhancement layer may include one or more recessions, i.e., areas where the material of the enhancement layer is thinner but where the recession does not extend fully through the enhancement layer to form a hole or slit. Holes and/or recessions in the enhancement layer may have a variety of shapes and dimensions, including elliptical, rectangular, circular, hexagonal, and irregular shapes, and may be arranged randomly or in a periodic lattice, which may have uniform or non-uniform periodicity.

In addition to achieving polarization control, correct design of the outcoupling structure in an OLED with an enhancement layer can result in highly directional emission. In these embodiments, the outcoupling layer includes periodic arrays of metallic structures to achieve wavefront shaping and beam steering for increased control of the directionality of the beam. The periodic nano structures on the outcoupling layer acts as a two-dimensional grating, which can diffract the emission from the OLED device to different angles depending on the array periodicity and emission wavelength. This enables one to make a display where the brightness can be increased within a desired solid angle. In some embodiments, the array periodicity may be tuned to match with the emission wave vector to increase the brightness along normal direction which would be beneficial for applications requiring high brightness such as AR/VR or OLED panels frequently operating in daylight. The array periodicity may be matches so as to outcouple a specific spectral region of light at the desired angle, such as at normal incidence. As an illustrative example, if outcoupling red light preferentially at normal incidence compared to the substrate requires an array with a periodicity of 300 nm, then outcoupling green light preferentially at normal incidence may require an array of 250 nm or less.

As previously disclosed, another approach to improving the efficiency of plasmonic displays is to reduce the ambient light reflected from the OLED sub-pixels using the outcoupling structure, without using any additional polarization control elements. Such an arrangement simplifies the manufacturing of OLED displays significantly while allowing almost 100% light transmission from the OLED pixels of the display.

In an embodiment, a plasmonic OLED incorporates random arrays of metal nanostructures, separated from the enhancement layer by a dielectric material layer as shown in FIGS. 15A-D. n this embodiment, the purpose of the metal nanostructures in the outcoupling layer is two-fold. First, to outcouple energy in the surface plasmon mode of the enhancement layer for one specific color. The second purpose is to absorb incident radiation in other color regions. In some embodiments, to increase the absorption of the outcoupling layer at colors which it is not outcoupling light, the dielectric layer may have a thickness of 5-30 nm, less than 30 nm, less than 20 nm, less than 10 nm, or less than 5 nm, and a refractive index of less than 3, less than 2, less than 1.5, or less than 1.2. Due to the random arrangement of the metal nanoparticles, the outcoupled light from the OLED will be predominantly unpolarized. Such an arrangement may be selected specifically where unpolarized emission is desired. The randomly-arranged nanoparticles may have in-plane dimensions and/or out-of-plane dimensions in the range of 20-250 nm. Alternatively, unpolarized emission can be achieved by using randomly arranged holes or recessions in the enhancement layer or an outcoupling layer with randomly arranged holes or recession above the enhancement layer which serves as an outcoupling layer with an dielectric layer between them. For an unpolarized emission the absolute values of Stokes parameters $S_1, S_2$ and $S_3 \approx 0$.

As previously disclosed, metal nanostructures in an outcoupling layer as disclosed herein may include silver, gold, aluminum, or combinations thereof and may have shapes with planar base area such as nanocubes (15A), hemispheres (15B), square pyramids (15C), triangular pyramids (15D), and the like, as shown in FIGS. 15A-D. The nanoparticles coupled to the enhancement layer form cavity-like modes between the flat faces of the metal nanoparticles and the enhancement layer, which results in strong absorption of the incident light for the wavelength regions where the coupling conditions are satisfied. In some embodiments, the wavelengths of light where strong absorption occur are not at the wavelengths of light where strong emission occurs for the outcoupling layer. In some embodiments, the overall ambient light reflected by the device in the visible range (i.e., approximately 400-700 nm) may be less than 10%, more preferably less than 7%, more preferably less than 5%.

The absorbed incident light by the outcoupling structures will be dissipated by the generation and decay of the surface plasmon in the enhancement layer. FIG. 16 shows the simulated reflectance from a plasmonic OLED device utilizing randomly distributed silver nanocubes on a 10 nm thick dielectric material above the silver cathode. The dip in reflectance around 550 nm for incident angle 45° and 60° indicate the excitation of gap modes which absorb light and reduce the ambient light reflection in the wavelength region. At the same time, the metal nanoparticles coupled to the enhancement layer act as an optical nano patch antenna for the EL emission from the device, enabling the outcoupling of light from the OLEDs. In some embodiments, the light absorption will be tuned to have considerable overlap with the EL emission wavelength, which can be achieved by controlling the gap layer thickness, particle size and dimensions.

In some embodiments where the ambient light absorption by the outcoupling structures is limited to smaller wavelength regions near EL emission wavelength, an absorptive band pass filter with transmission band matching the EL emission may be used above the OLED devices to achieve the ambient light absorption in the entire visible region as shown in FIG. 17B. In other embodiments, the nanoparticle based outcoupling layer when place on top of the cathode and dielectric layer can absorb a significant fraction or even nearly all the ambient emission across a wide spectral range. In some embodiments, the reflection from the OLED device is less than 10% when averaged across the spectral range of 400 nm to 700 nm. More preferably, the reflection from the device is less than 7%, even more preferably the ambient reflection is less than 5%. In some embodiments an absorptive filter which absorbs ultra-violet (UV) wavelengths is added to the OLED display. In some embodiments an anti-reflection layer is added to the OLED display. This anti-reflection layer may be added to the encapsulation layer. In some embodiments, a filter or down conversion layer may be used to modify the EL spectrum from the outcoupling layer. For example, a color filtering layer may be added to increase the color saturation from the device.

In an embodiment, light-absorptive materials such as fluorescent dyes or semiconducting quantum dots may be included in the dielectric layer to enhance the light absorption. An example of such an arrangement is shown in FIG. 17C. In this arrangement, a stronger extinction coefficient of the material is preferred. However, even weaker absorbing materials may be acceptable due to the enhanced electric field in the region between the outcoupling layer and the cathode. Dyes may be used such as Perylene, Boron di-pyrromethene, Rhodamine, Fluorescein, Fluorescein isothiocyanate, Calcein, Ethidiumbromide, Phycoerythrin, Carboxynaphthofluorescein, Hexachlorofluorescein, Tetramethylrhodamine, Phenylethynylpyrene or quantum confined nano crystals of cadmium selenide, cadmium sulfide, cadmium telluride, core shell cadmium selenide-zinc sulfide, core shell cadmium selenide-zinc selenide, lead sulfide, zinc selenide etc. as the absorbing materials. The absorbers may be dispersed in the dielectric layer of a plasmonic OLED as shown in FIG. 17C. The material or materials dispersed within the dielectric layer may be designed to have minimal absorption near the EL emission wavelength. The ambient light absorption by the absorbing material will be enhanced by the strong field enhancement in the region between the metallic nanoparticles and enhancement layer. In some embodiments, a band pass absorptive filter with transmission band matching the EL emission wavelength may be used above the OLED device to enable the light absorption in the entire visible region. In some embodiments, a filter or down conversion layer may be used to modify the EL spectrum from the outcoupling layer. For example, a color filtering layer may be added to increase the color saturation from the device.

EXPERIMENTAL

To demonstrate polarization control of the OLED emission in a plasmonic OLED, emission profiles of an OLED device were simulated and the associated Stoke's parameters were calculated from the simulated emission. The simulations were performed by finite difference time domain (FDTD) method using Ansys Lumerical FDTD solutions. Different layers of the OLED devices were rendered into a computational volume of 4 $\mu$m $\times$4 $\mu$m $\times$1.5 $\mu$m by their refractive index values and were enclosed within the perfectly matched layers (PML) in all directions to match the open boundary conditions. A single dipole emitter in vertical or horizonal orientation with broad emission spectrum covering the entire visible region (450 - 750 nm), placed 20 nm away from a 30 nm thick silver electrode acts as the emissive layer. We used a 75 nm thick non absorbing dielectric layer with refractive index of 1.7 to model the OLED's refractive index. The metallic structures comprising the outcoupling layer with optimum dimensions and ordering to achieve desired polarization changes of EL was placed above the enhancement layer which is also the cathode of the OLED. A dielectric layer of refractive index 1.38 and thickness 20 nm separates the outcoupling layer and cathode. We used experimentally-determined refractive index values to model the silver cathode and the industry-standard refractive values were used for modeling metallic structures in the outcoupling layer. The computational volume was discretized with a non-uniform index adjusted rectangular mesh with a resolution of 34 mesh cells per wavelength. Additionally, a mesh override region with 2 nm resolution were applied in the simulation region encompassing the silver cathode and metallic structures to minimize the computational error. The Purcell enhancement was estimated by calculating the power emitter by the dipole using a box of monitors surrounding the emitter normalized to the free space emission power. The light emission in the far field were recorded using a frequency-domain field and power monitor placed 500 nm above the outcoupling layer, which were used to estimate the external quantum efficiency (EQE) of the device. The monitor also records the electric and magnetic field components. Ambient light reflectance from the OLED was simulated using a plane wave light source placed 400 nm above the OLED and the reflected light from the device was recorded using the same frequency-domain field and power monitor. To calculate the Stoke's parameters, the far field projections of this monitor was simulated using the built-in simulation tool with a resolution of 200 x 200 pixels, which provides the s and p polarization components of the electric field projected to a hemisphere of radius 1 m. The wavelength resolved Stokes's parameters at each pixel were estimated using the equations

$$S_0 = E_p E_p^* + E_s E_s^*$$

$$S_1 = E_p E_p^* - E_s E_s^*$$

$$S_2 = E_p E_s^* + E_s E_p^*$$

$$S_3 = i(E_p E_s^* - E_s E_p^*)$$

where $E_s$, and $E_p$ are the s and p polarized components of complex electric field, and their complex conjugates are represented by an asterisk symbol. The effective Stoke's parameter for a particular wavelength was calculated by averaging over all pixels. The calculations were performed using a Lumerical script.

FIGS. 18A-C show the simulated EQE and Stoke's parameters for an outcoupling structure utilizing square array of two orthogonally arranged rectangular metal nano structures of different dimensions. The in-plane dimensions of the metal structures are 240 $\times$ 100 nm and 100 $\times$150 nm with height 200 nm, using a general device structure as shown in FIG. 6B with a square array of two orthogonally arranged silver rectangular nano structures of different dimensions as the outcoupling layer.

The plots depicted in FIG. 18A represents the estimated Stoke's parameters $S_1$,$S_2$ and $S_3$ for the vertical (solid curve) and horizontal (dashed curve) orientation of the dipole emitter. FIG. 18 B shows EQE variations with the polarizing elements for different emission wavelength for vertical (solid curve) and horizontal (dashed curve) orientation of the dipole emitter simulated using the FDTD method. Table 2 compares the EL transmission through the polarizing elements in a display panel for the wavefront tuned OLED device with a standard plasmon device utilizing randomly distributed silver nanocubes. Table 2 also summarizes the effective $S_3$ and EQE values estimated for a red phosphorescent emitter's spectrum with and without the polarizing elements, calculated by spectrally integrating the simulated EQE curve for the emitter's spectral shape shown in FIG. 18C. The estimation shows that the close to 75% of the EL can be transmitted through adisplay panel polarizing elements of a quarter waveplate and linear polarizer by utilizing the wavefront tuned OLED device, while the estimated EL transmission for a conventional plasmonic device is $\approx$ 50%. The emission from the conventional plasmonic OLED device is unpolarized with effective $S_3 \approx$0. The circularly polarized components in the EL emission from the wavefront tuned OLED results in an effective $S_3$ of 0.48. The total volume fraction of the metallic structures used in wavefront tuned OLED device simulations are 10 times lower than the conventional plasmonic OLED, which results in a lower EQE values for the wavefront tuned device before the polarizing elements. However, the effective EQE values of the OLEDs after the polarizing elements are comparable owing to the additional 50% enhancement in light transmission for the wavefront tuned OLED.

The estimated Stokes parameters for two additional outcoupling structures are shown in FIGS. 19A-D. FIG. 19A shows the schematics of an OLED device utilizing a rectangular array of cylindrical pillars of silver as the outcoupling layer. The radius and height of silver pillars are 50 nm and 100 nm respectively with array periodicity of 300 nm and 400 nm along two mutually orthogonal symmetry directions. The estimated Stoke's parameters for vertical and horizontal orientation of the dipole emitters for the OLED design depicted are shown in FIG. 19B. FIGS. 19C and 19D summarize the simulation results utilizing rectangular array of rectangular silver nano structures with in-plane dimensions 200 x 100 nm and height 100 nm as outcoupling layer. The lattice periodicity of the arrays along the longest and shortest dimension of the silver nano structures are 250 nm and 400 nm, respectively. FIG. 19D shows the estimated Stoke's parameters for vertical and horizontal orientation of the dipole emitters. The simulation results presented in Fig 16 shows $S_3$ values closer or exceeding 0.5 indicating strong circularly polarized components in the EL emission which could results in enhancement of the device brightness by a factor of 1.4 -1.5.

Table 2. Estimated EQE for a red emitting OLED device with and without the polarizing elements in the display panel, effective $S_3$ and fraction of EL transmitted through the polarizing elements in display panel for plasmon OLEDs device using random array of silver nano cubes with unpolarized emission and wavefront tuned plasmonic OLED.

| OLED device type | EQE with polarizing elements | EQE without polarizing elements | Effective S3 | EL Transmission ratio with polarizing elements |
|---|---|---|---|---|
| Plasmonic OLED with random Ag cube array | 14% | 28% | 0 | 0.5 |
| Wavefront tuned plasmonic OLED as shown | 12% | 18% | 0.49 | 0.75 |

As previously disclosed, in some embodiments it may be desirable for device emission to be linearly polarized or a desired combination of linear and circularly polarized. In such an embodiment, arrangements as disclosed herein may provide for emitted light to have a Stokes parameter $S_1$ and/or $S_2$ with an absolute of 0.1 or more, 0.1 to 0.5, 0.5 to 0.75, or 0.75-1. Concurrently, as previously disclosed, the device may have a Stokes parameter $S_3$ having an absolute value of 0.1 or more, 0.1-0.5, 0.5-0.75, or 0.75-1.

The present disclosure provides a variety of embodiments that may be used to achieve a desired emission by the OLED device. Such embodiments may be used in any combination unless explicitly described to the contrary or where such use in context of the present disclosure would be impossible, impractical, or undesirable. For example, unless indicated to the contrary or immediately clear from the surrounding context, any arrangement of outcoupling layer materials, nanostructure composition, size, and shape, and enhancement layer composition and arrangement may be used, even where any such feature is described with reference to a specific illustrative embodiment. Moreover, effects resulting from a particular arrangement or composition of nanostructures are believed to be achievable when such arrangement is used in conjunction with other features of devices as disclosed herein, whether described and shown in a single embodiment or in separate illustrative embodiments and arrangements.

It is understood that the various embodiments described herein are by way of example only, and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

In the following numbered aspects of the present invention are disclosed.

1. A device comprising:

a substrate;

a first electrode disposed over the substrate;

an organic emissive material disposed over the first electrode;

an enhancement layer comprising a plasmonic material that exhibits surface plasmon resonance disposed over the organic emissive material; and

an outcoupling layer comprising metal nanostructures disposed over the enhancement layer that causes light emitted by the device to have circular polarization with a Stokes parameter $S_3$ having an absolute value of 0.1 or greater.

2. The device of aspect 1, wherein the enhancement layer provides a second electrode for the device.

3. The device of aspect 1, further comprising: a quarter-wave plate and/or linear polarizer disposed over the out-coupling layer.

4. The device of aspect 1, wherein the enhancement layer comprise at least one material selected from the group consisting of: silver, gold, aluminum, palladium, platinum.

5. The device of aspect 1, wherein, for the light emitted by the device, $0.1 < |S_3| < 0.5$.

6. The device of aspect 1, wherein, for the light emitted by the device, $0.5 < |S_3| < 0.75$.

7. The device of aspect 1, wherein, for the light emitted by the device, $0.75 < |S_3| < 1$.

8. The device of aspect 1, further comprising a layer of dielectric material disposed between the enhancement layer and the outcoupling layer.

9. The device of aspect 8, wherein the thickness of the dielectric layer is less than 150 nm.

10. The device of aspect 9, wherein the thickness of the dielectric layer is less than 10 nm, less than 20 nm, less than 30 nm, less than 50 nm, or less than 100 nm.

11. The device of aspect 8, wherein the dielectric layer has a refractive index of less than 2.

12. The device of aspect 11, wherein the dielectric layer has a refractive index of less than 1.4, less than 1.6, or less than 1.8.

13. The device of aspect 1 wherein the metal nanostructures comprise at least one material selected from the group consisting of: silver, gold, aluminum, palladium, platinum.

14. The device of aspect 1, wherein the outcoupling layer comprises a plurality of unit cells, each unit cell comprising a pair of rectangular metal nanostructures having a major axis, wherein the pair of rectangular metal nanostructures is arranged such that the long axes are non-parallel and the edge-to-edge separation between the pair of rectangular nanostructures is shortest between closest ends of the pair.

15. The device of aspect 14, wherein the major axes of each pair of rectangular metal nanostructures in each unit cell are arranged at a relative angle of 75°-90°.

16. The device of aspect 14, wherein the major axes of each pair of rectangular metal nanostructures in each unit cell are arranged at a relative angle of 30°-60°.

17. The device of aspect 14, wherein the major axes of each pair of rectangular metal nanostructures in each unit cell are arranged at a relative angle of less than 30°.

18. The device of aspect 14, wherein the major axes of each pair of rectangular metal nanostructures in each unit cell are arranged at a relative angle of 60° or more.

19. The device of aspect 1, wherein the metal nanostructures are rectangular.

20. The device of aspect 1, where at least some of the metal nanostructures have a non-uniform cross-section in a direction perpendicular to the substrate.

21. The device of aspect 1, where at least some of the metal nanostructures have a non-uniform composition in a direction perpendicular to the substrate.

22. The device of aspect 21, wherein the composition comprises a dielectric material, and wherein the relative proportion of the dielectric material is non-uniform in the direction perpendicular to the substrate.

23. The device of aspect 8, wherein the metal nanostructures are arranged in a periodic lattice having different periodicities in orthogonal directions.

24. The device of aspect 23, wherein the metal nanostructures have a largest axis of less than 10 nm, less than 25 nm or less than 50 nm.

25. The device of aspect 23, wherein the metal nanostructures have one or more shapes selected from the group consisting of: spherical, cylindrical, star-shaped plates, hexagonal-shaped plates and random shaped structures.

26. The device of aspect 1, wherein the outcoupling layer comprises a dielectric material containing the metal nanostructures.

27. The device of aspect 26, wherein the dielectric material containing the metal nanostructures has a refractive index less than 1.4, less than 1.6, or less than 2.

28. The device of aspect 26, wherein the outcoupling layer has different effective indices of refraction along two orthogonal directions.

29. The device of aspect 23, wherein the metal nanostructures have in-plane dimensions of 50-500 nm.

30. The device of aspect 29, wherein the metal nanostructures have in-plane dimensions of at least 100 nm, at least 150 nm, or at least 250 nm.

31. The device of aspect 23, wherein the metal nanostructures have out-of-plane dimensions of 30-500 nm

32. The device of aspect 31, wherein the metal nanostructures have out-of-plane dimensions of at least 100 nm, at least 150 nm, or at least 250 nm.

33. The device of aspect 29, wherein the metal nanostructures have shapes selected from the group consisting of: cylinder, rectangles, cubes, rods, spheres, and hemispheres.

34. The device of aspect 23, wherein the edge-to-edge spacing of the metal nanostructures along one of the orthogonal directions is less than an average in-plane dimension of the metal nanostructures along the same direction.

35. The device of aspect 1, further comprising a dielectric material disposed under the metal nanostructures.

36. The device of aspect 23, further comprising a dielectric material disposed on at least some rows of the metal nanoparticle lattice.

37. The device of aspect 23, wherein the lattice comprises a plurality of rows of the metal nanostructures and metal nanostructures in a first of the plurality of rows have different composition and/or physical dimensions than metal nanoparticles in a second of the plurality of rows.

38. The device of aspect 1, wherein the metal nanostructures comprise elliptical bullseye nanostructures.

39. The device of aspect 38, wherein the bullseye nanostructures comprise concentric grooves and rings that create a $\pi/2$ phase difference between orthogonal components of light outcoupled by the outcoupling layer.

40. The device of aspect 1, wherein the metal nanostructures comprise multiple chiral plasmonic nanostructures.

41. The device of aspect 1, wherein the metal nanostructures comprise a chiral nematic phase of colloidal metal nanostructures.

42. The device of aspect 1, wherein the metal nanostructures comprise a chiral arrangement of rod-shaped metal nanostructures.

43. The device of aspect 42, wherein the rod-shaped nanostructures are dispersed in a cellulose nanocrystal medium to generate circular polarized light emission.

44. The device of aspect 42, wherein the outcoupling layer exhibits circular dichroism.

45. The device of aspect 42, wherein the nanoparticles are dispersed in a chiral thermotropic liquid crystal.

46. The device of aspect 3, wherein the device is a display panel, and the quarter-wave plate, linear polarizer, and/or the color filter are disposed over an entire active area of the display panel.

47. A consumer electronic device comprising:

a display panel comprising:

a substrate;
a first electrode disposed over the substrate;
an organic emissive material disposed over the first electrode;
an enhancement layer comprising a plasmonic material that exhibits surface plasmon resonance disposed over the organic emissive material; and
an outcoupling layer comprising metal nanostructures disposed over the enhancement layer that causes light emitted by the device to have circular polarization with a Stokes parameter S3 having an absolute value of 0.1 or greater

48. The consumer electronic device of aspect 47, wherein the device is at least one type selected from the group consisting of: a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video walls comprising multiple displays tiled together, a theater or stadium screen, and a sign.

49. A device comprising:

a substrate;
a first electrode disposed over the substrate;
an organic emissive material disposed over the first electrode;
an enhancement layer comprising plasmonic material that exhibits surface plasmon resonance; and
wherein:
the enhancement layer comprises a plurality of holes and/or recessions ; or
the device further comprises a dielectric layer disposed over the enhancement layer, and an outcoupling layer comprising a metal layer comprising holes and/or recessions disposed over the dielectric layer.

50. The device of aspect 49, further comprising:

a quarter-wave plate and/or polarizer disposed over the enhancement layer; and/or
a color filter disposed over the enhancement layer or outcoupling layer.

51. The device of aspect 49, wherein the holes and/or recessions have at least one shape selected from the group consisting of : ellipse, rectangle, circle, hexagonal, and irregular shapes.

52. The device of aspect 49, wherein the light emitted by the device is circularly polarized with a Stokes parameter $S_3$ having an absolute value greater than 0.1.

53. The device of aspect 49, wherein the light emitted by the device is linearly polarized a Stokes parameters $S_1$ and/or $S_2$ having an absolute value greater than 0.1.

54. The device of aspect 49, wherein, for the light emitted by the device, $0.1 < |S_3| < 0.5$.

55. The device of aspect 49, wherein, for the light emitted by the device, $0.5 < |S_3| < 0.75$.

56. The device of aspect 49, wherein, for the light emitted by the device, $0.75 < |S_3| < 1$.

57. The device of aspect 49, wherein, for the light emitted by the device, $0.1 < |S_1| < 0.5$ and/or $0.1 < |S_2| < 0.5$.

58. The device of aspect 49, wherein, for the light emitted by the device, $0.5 < |S_1| < 0.75$ and/or $0.5 < |S_2| < 0.75$.

59. The device of aspect 49, wherein, for the light emitted by the device, $0.75 < |S_1| < 1$ and/or $0.75 < |S_2| < 1$.

60. The device of aspect 49, wherein the arrangements of holes and/or recessions are random and emission from the device is unpolarized.

61. The device of aspect 49, wherein the holes and/or recession are arranged in a periodic lattice.

62. The device of aspect 49, wherein the device comprises the outcoupling layer and the refractive index of the dielectric layer is less than 1.4, less than 1.5, less than 1.8 and less than 2.

63. The device of aspect 49, wherein the device comprises the outcoupling layer and the outcoupling layer comprises at least one material selected from the group consisting of: silver, gold, aluminum, palladium, and platinum.

64. The device of aspect 49, wherein the enhancement layer comprise at least one material selected from the group consisting of: silver, gold, aluminum, palladium, platinum.

65. A device comprising:

a substrate;
a first electrode disposed over the substrate;
an organic emissive material disposed between the first electrode and the second electrode;
an enhancement layer comprising a plasmonic material that exhibits surface plasmon resonance; and
an outcoupling layer comprising metal nanostructures that causes light emitted by the device to have linear polarization with Stokes parameters $S_1$ and/or $S_2$ having an absolute value of 0.1 or greater.

66. The device of aspect 65, wherein for the light emitted by the device, $0.1 < |S_1| < 0.5$ and/or $0.1 < |S_2| < 0.5$.

67. The device of aspect 65, wherein for the light emitted by the device, $0.5 < |S_1| < 0.75$ and/or $0.5 < |S_2| < 0.75$.

68. The device of aspect 65, wherein for the light emitted by the device, $0.75 < |S_1| < 1$ and/or $0.75 < |S_2| < 1$.

69. A device comprising:

a first electrode;
a second electrode;
an organic emissive material disposed between the first electrode and the second electrode;
an enhancement layer comprising a plasmonic material that exhibits surface plasmon resonance, wherein the enhancement layer comprises the second electrode or the enhancement layer is a separate layer in the device; and
an outcoupling layer comprising metal nanostructures.

70. The device of aspect 69, further comprising:

a quarter-wave plate and/or linear polarizer disposed over the outcoupling layer; and/or
a color filter disposed over the outcoupling layer.

71. The device of aspect 70, wherein the device is a display panel, and the quarter-wave plate, linear polarizer, and/or the color filter are disposed over an entire active area of the display panel.

72. The device of aspect 69, further comprising a layer of dielectric material disposed between the enhancement layer and the outcoupling layer.

73. The device of aspect 72, wherein the arrangement of metal nanostructures is random and the emission from the device is unpolarized.

74. The device of aspect 73, wherein each of the metal nanostructures in the outcoupling layer has at least one flat face.

75. The device of aspect 73, wherein the metal nanostructures have shapes selected from the group consisting of: rectangular, star shaped plates, hexagonal shaped plates, triangular bipyramids, triangular pyramid, square pyramid and random shaped structures.

76. The device of aspect 73, wherein the layer of dielectric material has a thickness of 5-30 nm.

77. The device of aspect 73, wherein the layer of dielectric material has a thickness less than 30 nm, less than 20 nm, less than 10 nm, or less than 5 nm.

78. The device of aspect 73, wherein the dielectric material has a refractive index of less than 3, less than 2, less than 1.5, or less than 1.2.

79. The device of aspect 73, wherein the metal nanostructures couple to the enhancement layer to form an optical nano patch antenna to enhance the EL out coupling.

80. The device of aspect 73, wherein the metal nanostructures absorb ambient light by the excitation of cavity-like gap modes.

81. The device of aspect 80, wherein the ambient light absorption wavelength region due to the metal nanostructures is tuned to match with the EL emission wavelength.

82. The device of aspect 73, wherein the metal nanostructures have in-plane dimensions of 20-250 nm.

83. The device of aspect 73, wherein the metal nanostructures have out-of-plane dimensions of 20-250 nm.

84. The device of aspect 73, wherein overall ambient light reflection by the device in the 400-700 nm wavelength region is less than 10%, less than 7%, or less than 5%.

85. The device of aspect 80, wherein ambient light absorption by the outcoupling structures is limited to wavelength regions near an emission wavelength of the emissive layer.

86. The device of aspect 85, further comprising an absorptive band pass filter with transmission band matching an emission of the emissive layer.

87. The device of aspect 73, further comprising an absorptive filter that absorbs ultra violet (UV) light.

88. The device of aspect 73, further comprising an antireflecting coating.

89. The device of aspect 73, further comprising a color filter or down conversion layer arranged and configured to modify an emission spectrum of the outcoupling layer.

90. The device of aspect 73, wherein the dielectric material comprises fluorescence dyes and/or semiconducting quantum dots.

91. The device of aspect 90, wherein the dielectric material comprises one or more materials selected from the group consisting of: Perylene, Boron di-pyrromethene, Rhodamine, Fluorescein, Fluorescein isothiocyanate, Calcein, Ethidiumbromide, Phycoerythrin, Carboxynaphthofluorescein, Hexachlorofluorescein, Tetramethylrhodamine, Phenylethynylpyrene, and quantum-confined nano crystals of cadmium selenide, cadmium sulfide, cadmium telluride, core shell cadmium selenide-zinc sulfide, core shell cadmium selenide-zinc selenide, lead sulfide, and zinc selenide.

92. The device of aspect 90, wherein the dielectric materials have a light absorption of less than 5%, less than 10 %, or less than 25%.

93. The device of aspect 90, wherein light absorption of the dielectric material is enhanced by metal nanostructures in the outcoupling layer and/or the enhancement layer.

94. The device of aspect 90, further comprising an absorptive band pass filter with a transmission band matching emission of the emissive layer.

**Claims**

1.  A device comprising:

    a substrate;
    a first electrode disposed over the substrate;
    an organic emissive material disposed over the first electrode;
    an enhancement layer comprising a plasmonic material that exhibits surface plasmon resonance disposed over the organic emissive material; and
    an outcoupling layer comprising metal nanostructures disposed over the enhancement layer that causes light emitted by the device to have circular polarization with a Stokes parameter $S_3$ having an absolute value of 0.1 or greater.

2.  The device of claim 1, wherein the enhancement layer provides a second electrode for the device.

3.  The device of claim 1 or 2, further comprising: a quarter-wave plate and/or linear polarizer disposed over the outcoupling layer.

4.  The device of any of the preceding claims, further comprising a layer of dielectric material disposed between the enhancement layer and the outcoupling layer.

5.  The device of any of the preceding claims, wherein the outcoupling layer comprises a plurality of unit cells, each unit cell comprising a pair of rectangular metal nanostructures having a major axis, wherein the pair of rectangular metal nanostructures is arranged such that the long axes are non-parallel and the edge-to-edge separation between the pair of rectangular nanostructures is shortest between closest ends of the pair.

6.  The device of claim 5, wherein the major axes of each pair of rectangular metal nanostructures in each unit cell are arranged at a relative angle of 60° or more.

7.  The device of any of the preceding claims, where at least some of the metal nanostructures have a non-uniform composition in a direction perpendicular to the substrate.

8.  The device of claim 4, wherein the metal nanostructures are arranged in a periodic lattice having different periodicities in orthogonal directions.

9.  The device of any of the preceding claims, wherein the outcoupling layer comprises a dielectric material containing the metal nanostructures.

10. The device of claim 9, wherein the outcoupling layer has different effective indices of refraction along two orthogonal directions.

11. The device of claim 8, wherein the edge-to-edge spacing of the metal nanostructures along one of the orthogonal directions is less than an average in-plane dimension of the metal nanostructures along the same direction.

12. The device of any of the preceding claims, further comprising a dielectric material disposed under the metal nanostructures.

13. The device of claim 8, wherein the lattice comprises a plurality of rows of the metal nanostructures and metal nanostructures in a first of the plurality of rows have different composition and/or physical dimensions than metal nanoparticles in a second of the plurality of rows.

14. The device of any of the preceding claims, wherein the metal nanostructures comprise multiple chiral plasmonic nanostructures.

15. The device of claim 3, wherein the device is a display panel, and the quarter-wave plate, linear polarizer, and/or the color filter are disposed over an entire active area of the display panel.

# FIG. 1

100

170
160 { 164
162
155
150
145
140
135
130
125
120
115
110

# FIG. 2

200

230
225
220
215
210

## FIG. 3A

## FIG. 3B

# FIG. 4A

# FIG. 4B

Linear  Circular  Elliptical

**FIG. 5A**

**FIG. 5B**

Outcoupling
510

| Dielectric layer 520 |
| Enhancement layer 530 |
| OLED 100 |
| Substrate 110 |

**FIG. 5C**

| 520 |
| 530 |
| 100 |
| 110 |

**FIG. 5D**

| 520 |
| 530 |
| 100 |
| 110 |

**FIG. 5E**

| 520 |
| 530 |
| 100 |
| 110 |

Unit cell

1

2

Rectangular metal structures

Circular polarized EM field

# FIG. 6A

# FIG. 6B

Outcoupling layer
Dielectric layer
Enhancement layer
OLED

FIG. 6C

FIG. 7

# FIG. 8A

Rectangular array of
metallic nano structures

510
520
530
135

100

# FIG. 8B

810
820

Metallic nano structures

# FIG. 8C

Metallic nano structures

# FIG. 8D

Metallic nano structures

Dielectric

830

# FIG. 8E

Metallic nano structures

510
520
530
135

# FIG. 9A

# FIG. 9B

Circular polarized
EM field

910

# FIG. 9C

510/910

520

530

135

# FIG. 10A

## FIG. 10B

Outcoupling layer with chiral nanostructures

Dielectric layer
Electrode
EML layer
OLED

## FIG. 10C

Outcoupling layer with chiral nanostructures

Dielectric layer
Electrode
EML layer
OLED

# FIG. 10D

Outcoupling layer with chiral nanostructures
Dielectric layer
Electrode
EML layer
OLED

# FIG. 11A

Outcoupling layer
Dielectric layer
Enhancement layer
EML layer
OLED

# FIG. 11B

Colloidal solution of cellulose nanocrystals

Colloidal solution of rod-shaped metallic nanoparticles

Water evaporation

Rod-shaped metallic nanorods in cellulose medium

1210

# FIG. 12A

Switching voltage

Outcoupling layer
Dielectric layer
Enhancement layer
EML layer
OLED

FIG. 12B

**FIG. 13A**

Linear patch array

Outcoupling layer
Dielectric layer
Enhancement layer
OLED

**FIG. 13B**

Linear slit array on Ag contact

Enhancement layer
OLED

**FIG. 13C**

Linear slit array above dielectric layer

Outcoupling layer
Dielectric layer
Enhancement layer
OLED

**FIG. 14A**

Arbitrary Polarization

Outcoupling layer

Dielectric layer

Enhancement layer

OLED

θ

**FIG. 14B**

Arbitrary Polarization using elliptical slits

Enhancement layer

OLED

**FIG. 14C**

Arbitrary Polarization using elliptical slits above dielectric layer

Outcoupling layer

Dielectric layer

Enhancement layer

OLED

## FIG. 15A

Nanoparticles
Dielectric layer
Enhancement layer
EML layer
OLED

## FIG. 15B

Nanoparticles
Dielectric layer
Enhancement layer
EML layer
OLED

## FIG. 15C

Nanoparticles
Dielectric layer
Enhancement layer
EML layer
OLED

## FIG. 15D

Nanoparticles
Dielectric layer
Enhancement layer
EML layer
OLED

## FIG. 15E

Electrode with
holes/ recession

EML layer

OLED

## FIG. 15F

Outcoupling layer -
Metal layer with
holes/recession

Dielectric layer

Electrode

EML layer

OLED

# FIG. 16

Reflectance (%)

40

30

20

450    500    550    600    650    700    750

Wavelength (nm)

# FIG. 17A

→ Polarizer

→ Quarter waveplate

→ Encapsulation layer

→ Cathode

→ EML layer

→ OLED

# FIG. 17B

→ Absorptive Filter

→ Encapsulation layer

→ Outcoupling layer
→ Dielectric layer
→ Enhancement layer
→ EML layer

→ OLED

**FIG. 17C**

Filter
Encapsulation layer
Outcoupling layer
Dielectric layer doped with absorbing dyes
Enhancement layer
OLED

**FIG. 18B**

**FIG. 18A**

**FIG. 18C**

## FIG. 19A

## FIG. 19C

## FIG. 19B

## FIG. 19D

FIG. 20A

Electrode with holes/ recession
EML layer
OLED

FIG. 20B

Electrode with holes/ recession
EML layer
OLED

FIG. 20C

Outcoupling layer - Metal layer with holes/recession
Dielectric layer
Electrode
EML layer
OLED

FIG. 20D

Outcoupling layer - Metal layer with holes/recession
Dielectric layer
Electrode
EML layer
OLED

Europäisches Patentamt
European Patent Office
Office européen des brevets

# EUROPEAN SEARCH REPORT

**Application Number**

EP 22 20 7241

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2021/249633 A1 (FUSELLA MICHAEL [US] ET AL) 12 August 2021 (2021-08-12) | 1,2,4-7, 9-12,14 | INV. H10K59/80 H10K50/86 H10K50/858 H10K50/828 |
| Y | * page 9, paragraph 22 – paragraph 24; claims 1-16; figure 5a * <br> * page 23 – page 24; tables 1, 2 * <br> * page 42, paragraph 263 * <br> ----- | 3,8,13, 15 | |
| Y | US 2005/194896 A1 (SUGITA TATSUYA [JP] ET AL) 8 September 2005 (2005-09-08) <br> * claims 1-23; figure 9 * <br> ----- | 3,8,13, 15 | |

TECHNICAL FIELDS SEARCHED (IPC)

H10K

The present search report has been drawn up for all claims

| Place of search | Date of completion of the search | Examiner |
|---|---|---|
| The Hague | 16 March 2023 | Parashkov, Radoslav |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 20 7241

This annex lists the patent family members relating to the patent documents cited in the above-mentioned European search report.
The members are as contained in the European Patent Office EDP file on
The European Patent Office is in no way liable for these particulars which are merely given for the purpose of information.

16-03-2023

| Patent document cited in search report | | Publication date | Patent family member(s) | | Publication date |
|---|---|---|---|---|---|
| US 2021249633 | A1 | 12-08-2021 | NONE | | |
| US 2005194896 | A1 | 08-09-2005 | CN | 1665361 A | 07-09-2005 |
| | | | JP | 5005164 B2 | 22-08-2012 |
| | | | JP | 2005251488 A | 15-09-2005 |
| | | | KR | 20060043366 A | 15-05-2006 |
| | | | TW | I303498 B | 21-11-2008 |
| | | | US | 2005194896 A1 | 08-09-2005 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63278640
- US 5844363 A
- US 6303238 B
- US 5707745 A
- US 7279704 B
- US 4769292 A
- US 20030230980
- US 5703436 A
- US 6097147 A
- US 20040174116
- US 6537688 B
- US 6597111 B
- US 6664137 B
- US 6835950 B
- US 6888305 B
- US 6888307 B
- US 6897474 B
- US 7187119 B
- US 7683534 B

- US 5247190 A, Friend
- US 6091195 A, Forrest
- US 5834893 A, Bulovic
- US 6013982 A
- US 6087196 A
- US 6337102 B, Forrest
- US 7431968 B
- US 6294398 B
- US 6468819 B
- US 7968146 B
- US 2007023098 W
- US 2009042829 W
- US 20170229663
- US 9960386 B
- US 11139442 B
- US 11217762 B
- US 20210265584
- US 20210249633

**Non-patent literature cited in the description**

- **BALDO et al.** Highly Efficient Phosphorescent Emission from Organic Electroluminescent Devices. *Nature,* 1998, vol. 395, 151-154

- **BALDO et al.** Very high-efficiency green organic light-emitting devices based on electrophosphorescence. *Appl. Phys. Lett.,* 1999, vol. 75 (3), 4-6